# EUROPEAN PATENT APPLICATION

(11) **EP 4 270 451 A1**
(43) Date of publication of application: **01.11.2023**
(21) Application number: 21910247.2
(22) Date of filing: 06.12.2021
(51) Int. Cl.: H01L 21/3205, H01L 21/768, H01L 23/522, H01L 27/146, H04N 5/369

(54) **SOLID-STATE IMAGING DEVICE AND METHOD FOR MANUFACTURING SAME**

(30) Priority: 25.12.2020 JP 2020217541
(71) Applicant: Sony Semiconductor Solutions Corporation, Atsugi-shi, Kanagawa 243-0014 (JP)
(72) Inventor: YAMAMOTO, Junpei, Atsugi-shi, Kanagawa 243-0014 (JP)
(74) Representative: MFG Patentanwälte Meyer-Wildhagen Meggle-Freund Gerhard PartG mbB
(86) International application number: PCT/JP2021/044625
(87) International publication number: WO 2022/138097

(57) **Abstract**

Provided is a solid-state imaging device capable of suitably forming a pixel separation section in a pixel separation groove, and a method for manufacturing the solid-state imaging device.

A solid-state imaging device of the present disclosure includes a first substrate, a plurality of photoelectric conversion sections provided in the first substrate, and a pixel separation section provided between the photoelectric conversion sections in the first substrate and provided on a side surface of the first substrate that is a {100} plane.

## Description

### TECHNICAL FIELD

The present disclosure relates to a solid-state imaging device and a method for manufacturing the same.

### BACKGROUND ART

When the pixel size of a solid-state imaging device is reduced, light that should enter the photoelectric conversion section of a certain pixel enters the photoelectric conversion section of another pixel, and crosstalk may occur between the pixels. Therefore, a pixel separation groove that annularly surrounds the photoelectric conversion sections for each photoelectric conversion section may be provided in the substrate.

### CITATION LIST

### PATENT DOCUMENT

Patent Document 1: Japanese Patent Application Laid-Open No. 2013-175494
Patent Document 2: Japanese Patent Application Laid-Open No. 2018-148116

### SUMMARY OF THE INVENTION

### PROBLEMS TO BE SOLVED BY THE INVENTION

In the pixel separation groove, an insulating film such as an oxide film and a light shielding film such as a metal film are often embedded in order as a pixel separation section. In this case, when the pixel size of the solid-state imaging device is reduced, the ratio of the size of the insulating film to the size of the photoelectric conversion section increases, and there are problems that the size of the photoelectric conversion section is too small and the size of the pixel separation groove is too large. For example, if the size of the photoelectric conversion section is too small, the performance such as dark current characteristics of the photoelectric conversion section deteriorates.

Therefore, the present disclosure provides a solid-state imaging device capable of suitably forming a pixel separation section in a pixel separation groove, and a method for manufacturing the solid-state imaging device.

### SOLUTIONS TO PROBLEMS

A solid-state imaging device according to a first aspect of the present disclosure includes: a first substrate including a first semiconductor substrate; a plurality of photoelectric conversion sections provided in the first semiconductor substrate; and a pixel separation section provided between the plurality of photoelectric conversion sections in the first semiconductor substrate, in which an interface between a side surface of the pixel separation section and the first semiconductor substrate has a {100} plane. As a result, for example, the size of the pixel separation section can be reduced or the like, and the pixel separation section can be suitably formed in the pixel separation groove.

Furthermore, in the first aspect, the pixel separation section may include an insulating film. As a result, for example, a thin insulating film can be formed for the pixel separation section, and as a result, the size of the pixel separation section can be reduced.

Furthermore, in the first aspect, the pixel separation section may further include a light shielding film. As a result, for example, by forming a thin insulating film for the pixel separation section, a thick light shielding film can be formed for the pixel separation section.

Further, in the first aspect, the insulating film may contain an element contained in the first semiconductor substrate and oxygen. Thus, for example, the insulating film can be formed by oxidizing the side surface of the first semiconductor substrate.

Furthermore, in the first aspect, the insulating film may include a first portion having a first film thickness in plan view, and a second portion provided at a corner portion of the pixel separation section and having a second film thickness thicker than the first film thickness. As a result, for example, it is possible to reduce the overall film thickness of the insulating film by limiting the thick portion of the insulating film to the corner portion of the pixel separation section.

Furthermore, in the first aspect, the pixel separation section may include a plurality of first portions extending in a first direction parallel to a surface of the first semiconductor substrate in plan view, and a plurality of second portions extending in a second direction parallel to the surface of the first semiconductor substrate. As a result, for example, it is possible to implement a pixel separation section having a mesh-like planar shape.

Furthermore, in the first aspect, the plan view may correspond to a state in which a light incident surface of the first semiconductor substrate is viewed. As a result, for example, in a case where the first semiconductor substrate is viewed in the thickness direction thereof, it is possible to reduce the overall film thickness of the insulating film by limiting the thick portion of the insulating film to the corner portion of the pixel separation section.

Furthermore, in the first aspect, the first or second direction may be parallel to a <100> direction of the first semiconductor substrate. Thus, for example, by making the side surface of the first semiconductor substrate parallel to the first or second direction, the side surface of the first semiconductor substrate can be a {100} plane.

Furthermore, in the first aspect, the pixel separation section may be provided in a pixel separation groove penetrating the first semiconductor substrate. As a result, for example, the pixel separation section can be suitably formed in the pixel separation groove penetrating the first semiconductor substrate.

Furthermore, in the first aspect, the pixel separation section may be provided in a pixel separation groove that does not penetrate the first semiconductor substrate. As a result, for example, the pixel separation section can be suitably formed in the pixel separation groove that does not penetrate the first semiconductor substrate.

Furthermore, the solid-state imaging device of the first aspect may further include: a first insulating layer provided on a side opposite to a light incident surface of the first substrate; and a second substrate including a second semiconductor substrate provided so as to face the first insulating layer, in which the second substrate includes a transistor. As a result, for example, it is possible to use the second semiconductor substrate suitable for the transistor while using the first semiconductor substrate suitable for the pixel separation section.

Furthermore, in the first aspect, the pixel separation section may include a plurality of first portions extending in a first direction parallel to a surface of the first semiconductor substrate in plan view, and a plurality of second portions extending in a second direction parallel to the surface of the first semiconductor substrate. As a result, for example, it is possible to implement a pixel separation section having a mesh-like planar shape.

Furthermore, in the first aspect, the first or second direction may be parallel to a <110> direction of the second semiconductor substrate, and the transistor may be an n-type planar transistor having a channel direction parallel to the <110> direction. As a result, for example, a second semiconductor substrate suitable for an n-type planar transistor can be used.

Furthermore, in the first aspect, the first or second direction may be parallel to a <100> direction of the second semiconductor substrate, and the transistor may be a fin-type transistor having a fin sidewall that is a {100} plane of the second semiconductor substrate and having a channel direction parallel to the first or second direction. As a result, for example, the fin-type transistor can be suitably formed in the second substrate in which the first or second direction is parallel to the <100> direction.

Furthermore, in the first aspect, the first or second direction may be parallel to a <100> direction of the second semiconductor substrate, and the transistor may be a p-type planar transistor having a channel direction parallel to the <100> direction. As a result, for example, a second semiconductor substrate suitable for a p-type planar transistor can be used.

Furthermore, in the first aspect, the first or second direction may be parallel to a <110> direction of the second semiconductor substrate, and the transistor may be a fin-type transistor having a fin sidewall that is a {100} plane of the second semiconductor substrate and having a channel direction non-parallel to the first and second directions. As a result, for example, the fin-type transistor can be suitably formed in the second semiconductor substrate in which the first or second direction is parallel to the <110> direction.

A solid-state imaging device according to a second aspect of the present disclosure includes: a first substrate including a first semiconductor substrate; a plurality of photoelectric conversion sections provided in the first semiconductor substrate; and a pixel separation section provided between the plurality of photoelectric conversion sections in the first semiconductor substrate, in which the pixel separation section includes an insulating film, and the insulating film includes a first portion having a first film thickness in plan view, and a second portion provided at a corner portion of the pixel separation section and having a second film thickness thicker than the first film thickness. As a result, for example, the size of the pixel separation section can be reduced or the like, and the pixel separation section can be suitably formed in the pixel separation groove. For example, by limiting the thick portion of the insulating film for the pixel separation section to the corner portion of the pixel separation section, the overall film thickness of the insulating film for the inside of the pixel separation section can be reduced.

A method for manufacturing a solid-state imaging device according to a third aspect of the present disclosure includes: forming a plurality of photoelectric conversion sections in a first semiconductor substrate of a first substrate; and forming a pixel separation section between the plurality of photoelectric conversion sections in the first semiconductor substrate, in which the pixel separation section is formed such that an interface between a side surface of the pixel separation section and the first semiconductor substrate has a {100} plane. As a result, for example, the size of the pixel separation section can be reduced or the like, and the pixel separation section can be suitably formed in the pixel separation groove.

Furthermore, in the third aspect, the pixel separation section may be formed to include an insulating film. As a result, for example, a thin insulating film can be formed on the side surface of the first substrate, and as a result, the size of the pixel separation section can be reduced.

Furthermore, in the third aspect, the insulating film may be formed to include a first portion having a first film thickness in plan view, and a second portion provided at a corner portion of the pixel separation section and having a second film thickness thicker than the first film thickness. As a result, for example, it is possible to reduce the overall film thickness of the insulating film by limiting the thick portion of the insulating film to the corner portion of the pixel separation section.

### BRIEF DESCRIPTION OF DRAWINGS

Fig. 1 is a block diagram illustrating a configuration of a solid-state imaging device according to a first embodiment.
Fig. 2 is a cross-sectional view and a plan view illustrating a structure of the solid-state imaging device of the first embodiment.
Fig. 3 is a plan view for explaining a structure of the solid-state imaging device of the first embodiment.
Fig. 4 is another cross-sectional view illustrating a structure of the solid-state imaging device of the first embodiment.
Fig. 5 is another cross-sectional view illustrating a structure of the solid-state imaging device of the first embodiment.
Fig. 6 is a cross-sectional view (1/3) illustrating the method for manufacturing the solid-state imaging device of the first embodiment.
Fig. 7 is a cross-sectional view (2/3) illustrating the method for manufacturing the solid-state imaging device of the first embodiment.
Fig. 8 is a cross-sectional view (3/3) illustrating the method for manufacturing the solid-state imaging device of the first embodiment.
Fig. 9 is a cross-sectional view and a plan view illustrating a structure of a solid-state imaging device according to a second embodiment.
Fig. 10 is a cross-sectional view and a plan view illustrating a structure of a solid-state imaging device of a third embodiment.
Fig. 11 is a cross-sectional view and a plan view illustrating a structure of a solid-state imaging device according to a fourth embodiment.
Fig. 12 is a cross-sectional view and a plan view illustrating a structure of a solid-state imaging device according to a modification of the fourth embodiment.
Fig. 13 is a cross-sectional view and a plan view illustrating a structure of a solid-state imaging device according to a fifth embodiment.
Fig. 14 is a cross-sectional view and a plan view illustrating a structure of a solid-state imaging device according to a modification of the fifth embodiment.
Fig. 15 is a cross-sectional view and a plan view illustrating a structure of a solid-state imaging device of a sixth embodiment.
Fig. 16 is a block diagram illustrating a configuration example of an electronic device.
Fig. 17 is a block diagram illustrating a configuration example of a moving body control system.
Fig. 18 is a plan view illustrating a specific example of a setting position of the imaging section in Fig. 17.
Fig. 19 is a diagram illustrating an example of a schematic configuration of an endoscopic surgery system.
Fig. 20 is a block diagram illustrating an example of functional configurations of a camera head and a CCU.

### MODE FOR CARRYING OUT THE INVENTION

Hereinafter, embodiments of the present disclosure will be described with reference to the drawings.

### (First Embodiment)

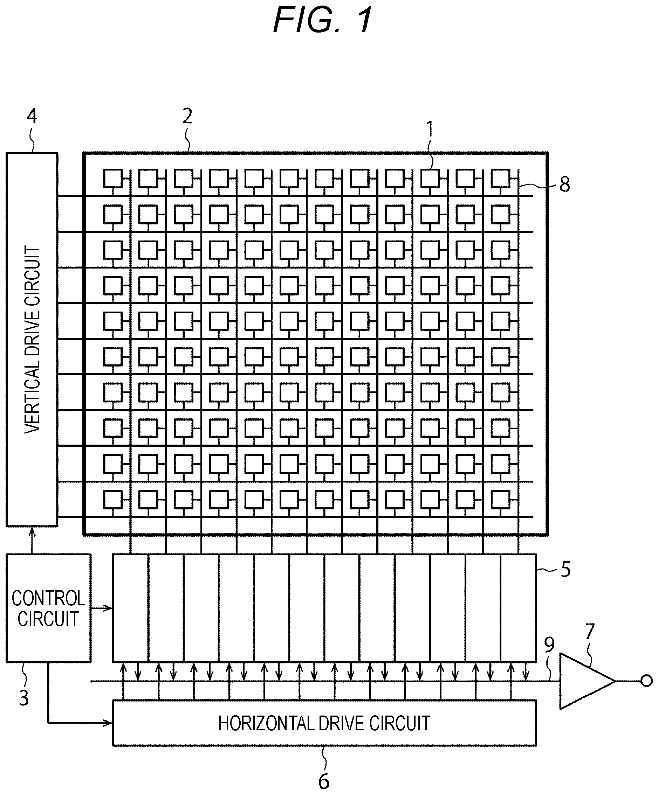

Fig. 1 is a block diagram illustrating a configuration of a solid-state imaging device according to a first embodiment.

The solid-state imaging device in Fig. 1 is a complementary metal oxide semiconductor (CMOS) type image sensor, and includes a pixel array region 2 having a plurality of pixels 1, a control circuit 3, a vertical drive circuit 4, a plurality of column signal processing circuits 5, a horizontal drive circuit 6, an output circuit 7, a plurality of vertical signal lines 8, and a horizontal signal line 9.

Each pixel 1 includes a photodiode functioning as a photoelectric conversion section and a MOS transistor functioning as a pixel transistor. Examples of the pixel transistor include a transfer transistor, a reset transistor, an amplification transistor, and a selection transistor. These pixel transistors may be shared by several pixels 1.

The pixel array region 2 includes a plurality of pixels 1 arranged in a two-dimensional array. The pixel array region 2 includes an effective pixel region that receives light, performs photoelectric conversion, amplifies and outputs a signal charge generated by the photoelectric conversion, and a black reference pixel region that outputs optical black serving as a reference of a black level. Generally, the black reference pixel region is arranged on an outer peripheral portion of the effective pixel region.

The control circuit 3 generates various signals serving as references of operations of the vertical drive circuit 4, the column signal processing circuit 5, the horizontal drive circuit 6, and the like on the basis of a vertical synchronization signal, a horizontal synchronization signal, a master clock, and the like. The signal generated by the control circuit 3 is, for example, a clock signal or a control signal, and is input to the vertical drive circuit 4, the column signal processing circuit 5, the horizontal drive circuit 6, and the like.

The vertical drive circuit 4 includes, for example, a shift register, and scans each pixel 1 in the pixel array region 2 in the vertical direction row by row. The vertical drive circuit 4 further supplies a pixel signal based on the signal charge generated by each pixel 1 to the column signal processing circuit 5 through the vertical signal line 8.

The column signal processing circuit 5 is arranged, for example, for each column of the pixels 1 in the pixel array region 2, and performs signal processing of the signals output from the pixels 1 of one row for each column on the basis of the signals from the black reference pixel region. Examples of this signal processing are noise removal and signal amplification.

The horizontal drive circuit 6 includes, for example, a shift register, and supplies the pixel signal from each column signal processing circuit 5 to the horizontal signal line 9.

The output circuit 7 performs signal processing on the signal supplied from each column signal processing circuit 5 through the horizontal signal line 9, and outputs the signal subjected to the signal processing.

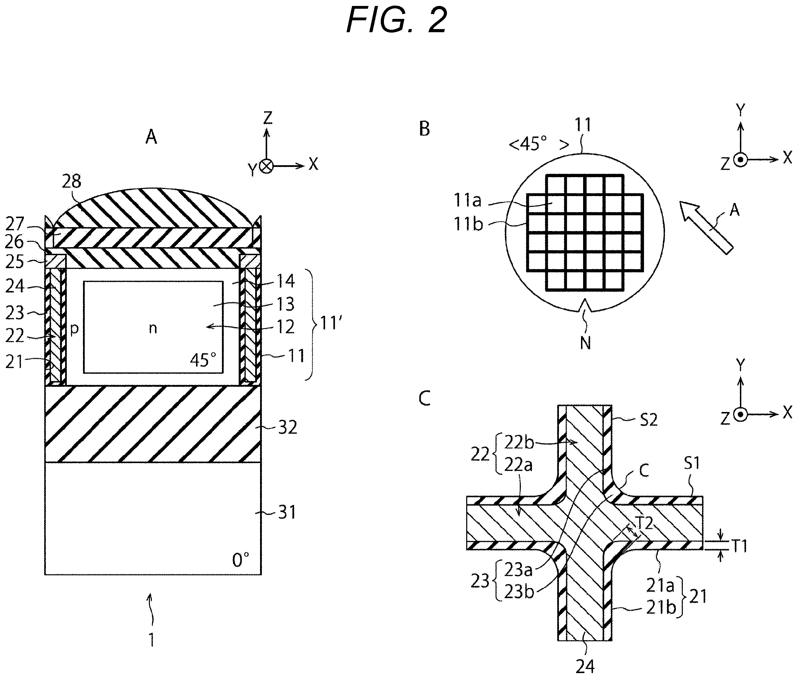

Fig. 2 is a cross-sectional view and a plan view illustrating a structure of the solid-state imaging device of the first embodiment.

A of Fig. 2 illustrates a longitudinal cross section of one pixel 1 in the pixel array region 2 of Fig. 1. As illustrated in A of Fig. 2, the solid-state imaging device of the present embodiment includes a semiconductor substrate 11, a photoelectric conversion section 12, an n-type semiconductor region 13, a p-type semiconductor region 14, a pixel separation groove 21, a pixel separation section 22, an insulating film 23, a light shielding film 24, a light shielding film 25, a flattening film 26, a color filter 27, an on-chip lens 28, a substrate 31, and an insulating layer 32. The semiconductor substrate 11 is an example of a first semiconductor substrate of the present disclosure. The solid-state imaging device of the present embodiment further includes a substrate 11' including a semiconductor substrate 11 and an insulating film 23. The substrate 11' is an example of a first substrate of the present disclosure.

A of Fig. 2 illustrates an X axis, a Y axis, and a Z axis perpendicular to each other. The X direction and the Y direction correspond to the lateral direction (horizontal direction), and the Z direction corresponds to the longitudinal direction (vertical direction). Furthermore, the +Z direction corresponds to the upward direction, and the -Z direction corresponds to the downward direction. The -Z direction may strictly match the gravity direction, or may not strictly match the gravity direction. One of the X direction and the Y direction is an example of a first direction of the present disclosure, and the other of the X direction and the Y direction is an example of a second direction of the present disclosure.

Hereinafter, the structure of the solid-state imaging device of the present embodiment will be described with reference to A of Fig. 2. In this description, B and C of Fig. 2 will also be referred to as appropriate. B of Fig. 2 is a plan view illustrating a structure of the substrate (wafer) 11 before dicing. C of Fig. 2 is a transverse cross-sectional view illustrating a structure of the pixel separation groove 21 and the pixel separation section 22.

The semiconductor substrate 11 is, for example, a silicon substrate. In A of Fig. 2, the surface (lower surface) of the semiconductor substrate 11 in the -Z direction is the front surface of the semiconductor substrate 11, and the surface (upper surface) of the semiconductor substrate 11 in the +Z direction is the back surface of the semiconductor substrate 11. Since the solid-state imaging device of the present embodiment is of a back-illuminated type, the back surface of the semiconductor substrate 11 serves as a light incident surface (light-receiving surface) of the semiconductor substrate 11. The back surface of the semiconductor substrate 11 is an example of a first surface of the present disclosure, and the front surface of the semiconductor substrate 11 is an example of a second surface of the present disclosure.

A and C of Fig. 2 illustrate the solid-state imaging device manufactured by dicing the semiconductor substrate 11, but B of Fig. 2 illustrates the semiconductor substrate 11 before dicing. The semiconductor substrate 11 illustrated in B of Fig. 2 includes a plurality of chip regions 11a and a dicing region 11b. The chip region 11a has a square or rectangular planar shape. The dicing region 11b has a planar shape annularly surrounding these chip regions 11a for each chip region 11a. In the present embodiment, the semiconductor substrate 11 is divided into these chip regions 11a by cutting the semiconductor substrate 11 in the dicing region 11b, and one solid-state imaging device is manufactured from each of the chip regions 11a.

B of Fig. 2 further illustrates a notch N of the semiconductor substrate 11. In B of Fig. 2, a notch N is provided on an end surface of the semiconductor substrate 11 in the -Y direction. The four sides of each chip region 11a extend in the X direction or the Y direction. The dicing region 11b has a mesh-like planar shape including a plurality of linear portions extending in the X direction and a plurality of linear portions extending in the Y direction.

The semiconductor substrate 11 of the present embodiment has a front surface and a back surface which are {100} planes, and is a <100> notch substrate (45° notch substrate). In the <100> notch substrate, the direction from the notch of the substrate toward the center of the substrate is the <100> direction. Therefore, in the semiconductor substrate 11 of the present embodiment, the +Y direction in the semiconductor substrate 11 is the <100> direction. An arrow A illustrated in B of Fig. 2 indicates a <110> direction in the semiconductor substrate 11. In B of Fig. 2, the inclination of the arrow A with respect to the +Y direction is 45°.

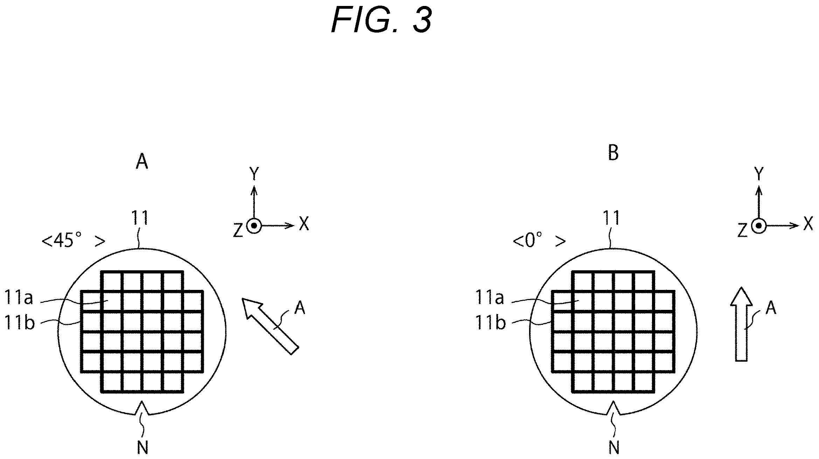

Fig. 3 is a plan view for explaining a structure of the solid-state imaging device of the first embodiment. Similarly to B of Fig. 2, A of Fig. 3 illustrates a <100> notch substrate (45° notch substrate) which is the semiconductor substrate 11 of the present embodiment, and B of Fig. 3 illustrates a <110> notch substrate (0° notch substrate) which is the semiconductor substrate 11 of a comparative example of the present embodiment. In the <110> notch substrate, the direction from the notch of the substrate toward the center of the substrate is the <110> direction. Therefore, in the semiconductor substrate 11 of the present comparative example, the +Y direction in the semiconductor substrate 11 is the <110> direction. An arrow A illustrated in B of Fig. 3 indicates a <110> direction in the semiconductor substrate 11. In B of Fig. 3, the inclination of the arrow A with respect to the +Y direction is 0°. Note that the semiconductor substrate 11 illustrated in B of Fig. 3 also has a front surface and a back surface which are {100} planes.

Subsequently, the structure of the solid-state imaging device of the present embodiment will be described with reference to A of Fig. 2.

The photoelectric conversion section 12 is provided for each pixel 1 in the semiconductor substrate 11. A of Fig. 2 illustrates one photoelectric conversion section 12 included in one pixel 1. The photoelectric conversion section 12 includes an n-type semiconductor region 13 provided in the semiconductor substrate 11 and a p-type semiconductor region 14 provided around the n-type semiconductor region 13 in the semiconductor substrate 11. In the photoelectric conversion section 12, a photodiode is implemented by a pn junction between the n-type semiconductor region 13 and the p-type semiconductor region 14, and the photodiode converts light into charges. The photoelectric conversion section 12 receives light from the back surface side of the semiconductor substrate 11, generates a signal charge according to the amount of received light, and accumulates the generated signal charge in the n-type semiconductor region 13.

The pixel separation groove 21 is provided in the semiconductor substrate 11, and specifically, is provided between the photoelectric conversion sections 12 of the pixels 1 adjacent to each other. The pixel separation groove 21 of the present embodiment penetrates the semiconductor substrate 11 from the back surface side of the semiconductor substrate 11 to the front surface side of the semiconductor substrate 11.

The pixel separation section 22 is provided in the pixel separation groove 21, and includes an insulating film 23 and a light shielding film 24 in order. The insulating film 23 is provided on the side surface and the bottom surface of the pixel separation groove 21, and the light shielding film 24 is provided on the side surface and the bottom surface of the pixel separation groove 21 with the insulating film 23 interposed therebetween. The insulating film 23 is, for example, a silicon oxide film. Since the insulating film 23 of the present embodiment is formed by oxidizing a side surface or the like of the semiconductor substrate 11, it contains a silicon (Si) element derived from the semiconductor substrate 11 and an oxygen (O) element derived from oxidation. The light shielding film 24 is, for example, a film containing a metal element such as tungsten (W), aluminum (Al), or copper (Cu), and has a function of shielding light.

C of Fig. 2 illustrates a cross section of the pixel separation groove 21 and the pixel separation section 22. The pixel separation groove 21 includes a plurality of first linear portions 21a extending in the X direction in plan view and a plurality of second linear portions 21b extending in the Y direction in plan view, and C of Fig. 2 illustrates one of the first linear portions 21a and one of the second linear portions 21b. Similarly, the pixel separation section 22 includes a plurality of first linear portions 22a extending in the X direction in plan view and a plurality of second linear portions 22b extending in the Y direction in plan view, and C of Fig. 2 illustrates one of the first linear portions 22a and one of the second linear portions 22b. One of the first linear portion 22a and the second linear portion 22b is an example of a first portion of the pixel separation section of the present disclosure, and the other of the first linear portion 22a and the second linear portion 22b is an example of a second portion of the pixel separation section of the present disclosure. Note that the above-described plan view of the present embodiment corresponds to a state in which the light incident surface of the semiconductor substrate 11 is viewed.

C of Fig. 2 further illustrates a side surface S1 extending in the X direction and a side surface S2 extending in the Y direction as side surfaces of the semiconductor substrate 11 in the pixel separation groove 21. C of Fig. 2 further illustrates a corner portion C between the side surface S1 and the side surface S2 as a corner portion of the semiconductor substrate 11 in the pixel separation groove 21. The corner portion C corresponds to a corner portion of the pixel separation section 22. The insulating film 23 of the present embodiment includes a first portion 23a formed on the side surface S1 or the side surface S2 and a second portion 23b formed at the corner portion C, and the film thickness (T2) of the second portion 23b is larger than the film thickness (T1) of the first portion 23a in plan view. The corner portion C is located in the second portion 23b. The film thickness of the first portion 23a is an example of the first film thickness of the present disclosure, and the film thickness of the second portion 23b is an example of the second film thickness of the present disclosure.

Here, the present embodiment is compared with the comparative example described above. Since the semiconductor substrate 11 of the comparative example described above is a <110> notch substrate, the side surface S1 and the side surface S2 are {110} planes. On the other hand, since the semiconductor substrate 11 of the present embodiment is a <100> notch substrate, the side surface S1 and the side surface S2 are {100} planes. In general, the {110} plane of the silicon substrate is more easily oxidized than the {100} plane of the silicon substrate. Therefore, in the comparative example described above, the first portion 23a becomes thick, and as a result, the size of the photoelectric conversion section 12 becomes small, and the size of the pixel separation section 22 becomes large. On the other hand, in the present embodiment, the first portion 23a becomes thin, and as a result, the size of the photoelectric conversion section 12 becomes large, and the size of the pixel separation section 22 becomes small. Therefore, according to the present embodiment, it is possible to suppress a decrease in the performance of the photoelectric conversion section 12 due to a reduction in the size of the photoelectric conversion section 12. As described above, the side surface S1 and the side surface S2 of the present embodiment are {100} planes, and the interface between the side surface of the pixel separation section 22 and the semiconductor substrate 11 of the present embodiment has a {100} plane.

As illustrated in C of Fig. 2, the planar shape of the corner portion C is generally not a perfect right angle but a curved shape. Therefore, a small {110} plane is generated in the corner portion C of the present embodiment, and the corner portion C of the present embodiment is more easily oxidized than the side surface S1 and the side surface S2. As a result, the film thickness of the second portion 23b of the present embodiment becomes thicker than the film thickness of the first portion 23a. According to the present embodiment, since the thick portion of the insulating film 23 can be limited to the corner portion C, the overall film thickness of the insulating film 23 can be reduced.

Note that the insulating film 23 of the present embodiment may be formed by, for example, radical oxidation. As a result, the film thickness of the first portion 23a and the film thickness of the second portion 23b can be made the same, and not only the film thickness of the first portion 23a but also the film thickness of the second portion 23b can be reduced.

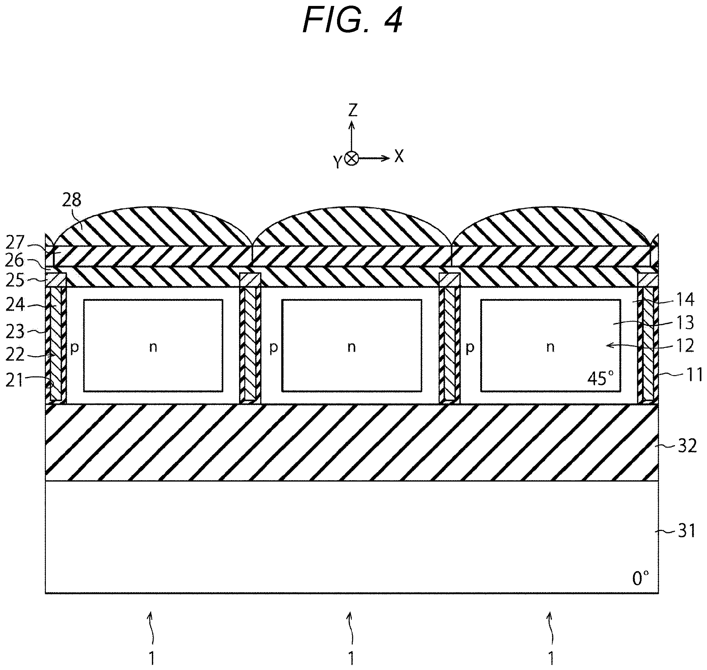

Fig. 4 is another cross-sectional view illustrating a structure of the solid-state imaging device of the first embodiment. Fig. 4 illustrates a longitudinal cross section of three pixels 1 in the pixel array region 2 of Fig. 1. As illustrated in Fig. 4, the solid-state imaging device according to the present embodiment includes a plurality of photoelectric conversion sections 12, and includes a pixel separation groove 21 and a pixel separation section 22 between the photoelectric conversion sections 12 adjacent to each other.

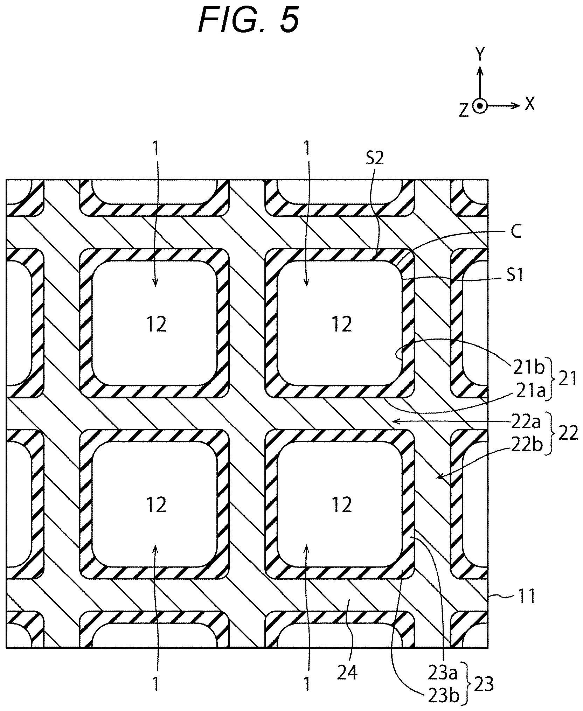

Fig. 5 is another cross-sectional view illustrating a structure of the solid-state imaging device of the first embodiment. Fig. 4 illustrates a cross section of the entirety of four pixels 1 and parts of 12 pixels 1 in the pixel array region 2 of Fig 1. As illustrated in Fig. 5, the solid-state imaging device according to the present embodiment includes a plurality of photoelectric conversion sections 12, and the pixel separation section 22 has a mesh-like planar shape annularly surrounding each of the photoelectric conversion sections 12 for each of the photoelectric conversion sections 12. Therefore, each photoelectric conversion section 12 is provided between the two first linear portions 22a adjacent to each other in the Y direction, and is provided between the two second linear portions 22b adjacent to each other in the X direction.

Subsequently, the structure of the solid-state imaging device of the present embodiment will be described with reference to A of Fig. 2.

The light shielding film 25 is provided on the pixel separation section 22 outside the semiconductor substrate 11. The light shielding film 25 is, for example, a film containing a metal element such as tungsten (W), aluminum (Al), or copper (Cu), and has a function of shielding light. The light shielding film 25 may be formed simultaneously with the light shielding film 24.

The flattening film 26 is formed on the semiconductor substrate 11 with the light shielding film 25 interposed therebetween so as to cover the back surface (upper surface) of the semiconductor substrate 11, whereby the surface on the back surface of the semiconductor substrate 11 is planarized. The flattening film 26 is, for example, an organic film such as a resin film.

The color filter 27 has a function of transmitting light having a predetermined wavelength, and is formed on the flattening film 26 for each pixel 1. For example, the color filters 27 for red (R), green (G), and blue (B) are arranged above the photoelectric conversion sections 12 of the red, green, and blue pixels 1, respectively. Furthermore, the color filter 27 for infrared light may be arranged above the photoelectric conversion section 12 of the pixel 1 for infrared light. The light transmitted through the color filter 27 enters the photoelectric conversion section 12 with the flattening film 26 interposed therebetween.

The on-chip lens 28 has a function of condensing incident light, and is formed on the color filter 27 for each pixel 1. The light condensed by the on-chip lens 28 enters the photoelectric conversion section 12 via the color filter 27 and the flattening film 26. Each on-chip lens 28 of the present embodiment is constituted by a material through which light passes, and the on-chip lenses 27 are connected to each other with this material interposed therebetween.

The substrate 31 is provided on the front surface (lower surface) of the semiconductor substrate 11 with the insulating layer 32 interposed therebetween, and is provided, for example, for securing the strength of the semiconductor substrate 11. The substrate 31 is, for example, a semiconductor substrate such as a silicon substrate. The substrate 31 of the present embodiment has a front surface and a back surface which are {100} planes, and is a <110> notch substrate (0° notch substrate). The insulating layer 32 is, for example, a laminated film including a silicon oxide film and another insulating film.

In the present embodiment, light incident on the on-chip lens 28 is condensed by the on-chip lens 28, transmitted through the color filter 27, and incident on the photoelectric conversion section 12. The photoelectric conversion section 12 converts the light into a charge by photoelectric conversion to generate a signal charge. The signal charge is output as a pixel signal via the vertical signal line 8 of Fig. 1.

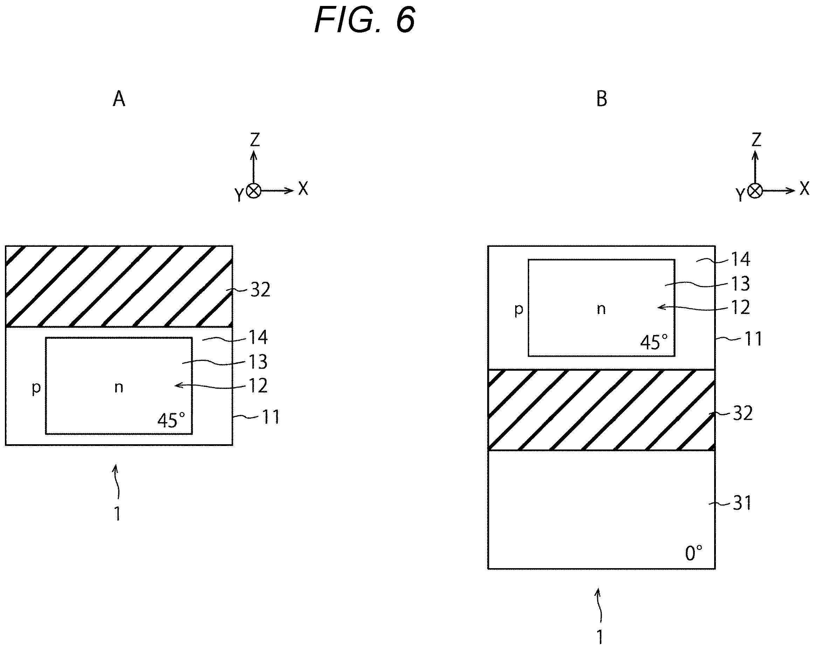

Figs. 6 to 8 are cross-sectional views illustrating the method for manufacturing the solid-state imaging device of the first embodiment.

First, the n-type semiconductor region 13 and the p-type semiconductor region 14 of each photoelectric conversion section 12 are formed in the semiconductor substrate 11, and the insulating layer 32 is formed on the semiconductor substrate 11 (A of Fig. 6). In this manner, the plurality of photoelectric conversion sections 12 is formed in the semiconductor substrate 11. The process illustrated in A of Fig. 6 is performed with the front surface of the semiconductor substrate 11 facing upward and the back surface of the semiconductor substrate 11 facing downward.

Next, the semiconductor substrate 11 is turned upside down (B of Fig. 6). As a result, the front surface of the semiconductor substrate 11 faces downward, and the back surface of the semiconductor substrate 11 faces upward. Next, the semiconductor substrate 11 is bonded to the surface (upper surface) of the substrate 31 with the insulating layer 32 interposed therebetween (B of Fig. 6).

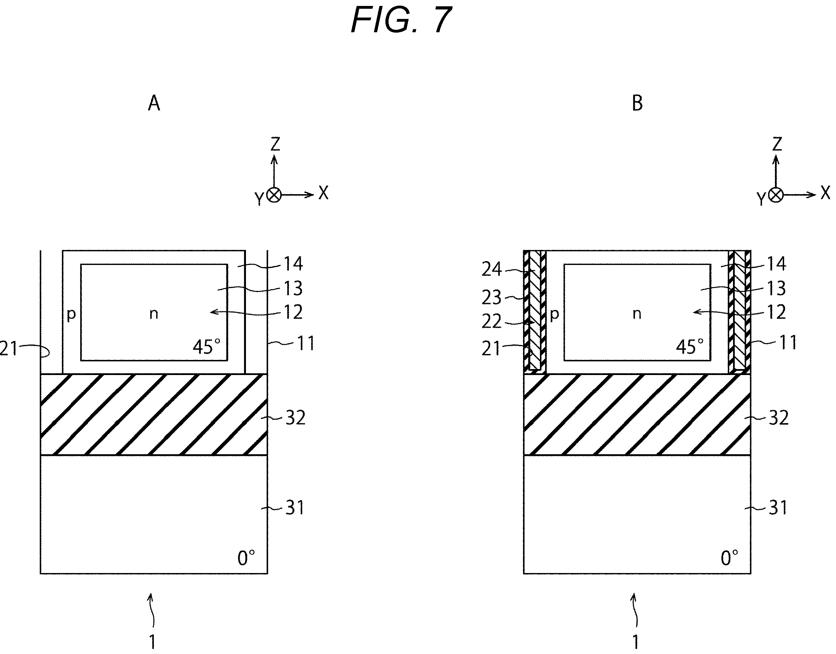

Next, the pixel separation groove 21 is formed in the semiconductor substrate 11 by dry etching (A of Fig. 7). The pixel separation groove 21 of the present embodiment is formed so as to penetrate the semiconductor substrate 11 and reach the insulating layer 32. Furthermore, the pixel separation groove 21 of the present embodiment is formed so as to have a mesh-like planar shape annularly surrounding the plurality of photoelectric conversion sections 12 described above for each photoelectric conversion section 12, and is formed between the photoelectric conversion sections 12 adjacent to each other.

Next, the insulating film 23 and the light shielding film 24 are sequentially formed in the pixel separation groove 21 (B of Fig. 7). As a result, the pixel separation section 22 including the insulating film 23 and the light shielding film 24 is formed in the pixel separation groove 21. The insulating film 23 is formed on the side surface and the bottom surface of the pixel separation groove 21, and the light shielding film 24 is formed on the side surface and the bottom surface of the pixel separation groove 21 with the insulating film 23 interposed therebetween.

Since the semiconductor substrate 11 of the present embodiment is a <100> notch substrate, the side surface of the semiconductor substrate 11 in the pixel separation groove 21 is a {100} plane. Therefore, according to the present embodiment, by forming the insulating film 23 on the side surface of the semiconductor substrate 11 in the pixel separation groove 21 by oxidation, the insulating film 23 including the first portion 23a having a thin film thickness and the second portion 23b having a thick film thickness can be formed (see C of Fig. 2).

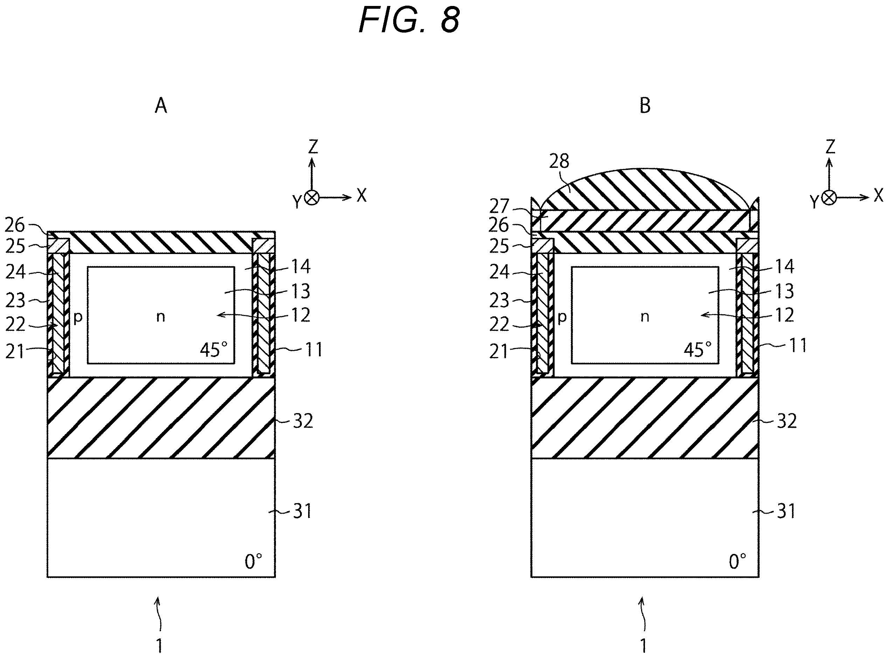

Next, the light shielding film 25 and the flattening film 26 are sequentially formed on the semiconductor substrate 11 (A of Fig. 8). The light shielding film 25 is formed on the pixel separation section 22, and the flattening film 26 is formed on the semiconductor substrate 11 so as to cover the light shielding film 25.

Next, the color filter 27 and the on-chip lens 28 are sequentially formed on the flattening film 26 above each photoelectric conversion section 12 (B of Fig. 8). Thereafter, the semiconductor substrate 11 is cut by the dicing region 11b, whereby the semiconductor substrate 11 is divided into individual chip regions 11a (see B of Fig. 2). In this way, the solid-state imaging device of the present embodiment is manufactured.

As described above, the pixel separation section 22 of the present embodiment is formed by forming the insulating film 23 on the side surface of the semiconductor substrate 11 which is the {100} plane. Therefore, according to the present embodiment, the pixel separation section 22 can be suitably formed in the pixel separation groove 21 such that, for example, the size of the pixel separation section 22 can be reduced by thinning the insulating film 23 or the like.

Note that the semiconductor substrate 11 of the present embodiment is a Si {100} substrate which is a front surface, a back surface, or a {100} plane, and is a <110> notch substrate in which the +Y direction is a <110> direction. Hereinafter, the meanings of the reference signs {xyz} and <xyz> described above will be supplemented using the Si {111} substrate and the <110> direction as an example.

The Si {111} substrate in the present disclosure is a substrate or a wafer including a silicon single crystal and having a crystal plane represented by {111} in the notation of the Miller indices. The Si {111} substrate in the present disclosure also includes a substrate or a wafer whose crystal orientation is shifted by several degrees, for example, shifted by several degrees from the {111} plane in the [110] direction that is the closest. Further, a silicon single crystal grown by an epitaxial method or the like on a part or the entire surface of these substrates or wafers is also included.

In addition, in the notation of the present disclosure, the {111} plane is a generic term for a (111) plane, a (-111) plane, a (1-11) plane, a (11-1) plane, a (-1-11) plane, a (-11-1) plane, a (1-1-1) plane, and a (-1-1-1) plane which are crystal planes equivalent to each other in symmetry. Therefore, the description of the Si {111} substrate in the specification and the like of the present disclosure may be read as, for example, a Si (1-11) substrate. Here, a minus sign is substituted for a bar sign for representing the index of the Miller index in the negative direction.

In addition, the <110> direction in the description of the present disclosure is a generic term for a [110] direction, a [101] direction, a [011] direction, a [-110] direction, a [1-10] direction, a [-101] direction, a [10-1] direction, a [0-11] direction, a [01-1] direction, a [-1-10] direction, a [-10-1] direction, and a [0-1-1] direction which are crystal plane directions equivalent to each other in symmetry, and may be read as any one.

### (Second Embodiment)

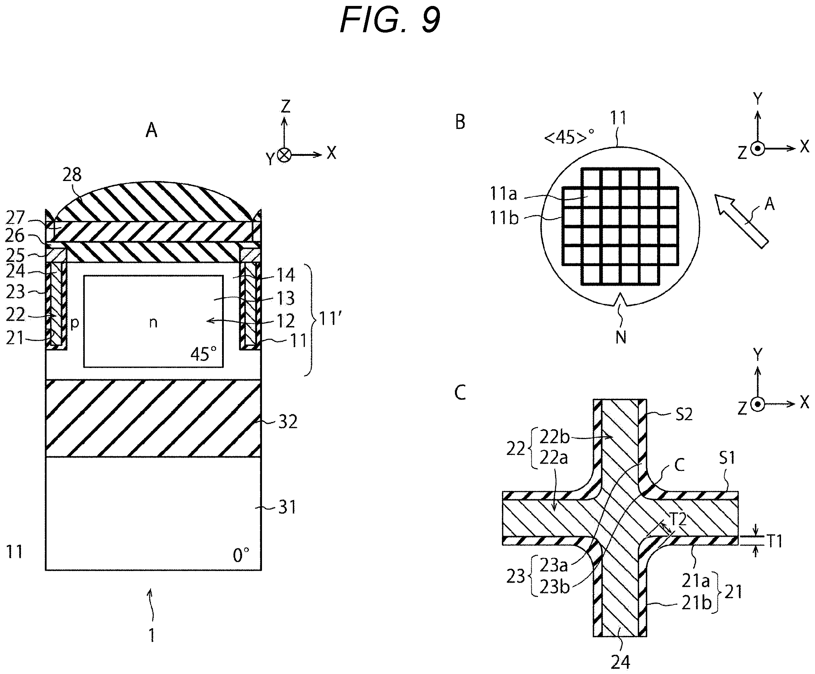

Fig. 9 is a cross-sectional view and a plan view illustrating a structure of a solid-state imaging device according to a second embodiment.

A of Fig. 9 illustrates a longitudinal cross section of one pixel 1 in the pixel array region 2 of Fig. 1, similarly to A of Fig. 2. B of Fig. 9 is a plan view illustrating a structure of the substrate (wafer) 11 before dicing, similarly to B of Fig. 2. Similarly to C of Fig. 2, C of Fig. 9 is a transverse cross-sectional view illustrating a structure of the pixel separation groove 21 and the pixel separation section 22.

As illustrated in A to C of Fig. 9, the solid-state imaging device of the present embodiment includes the same components as those of the solid-state imaging device of the first embodiment. However, the pixel separation groove 21 of the present embodiment is provided on the back surface (upper surface) side of the semiconductor substrate 11 so as not to penetrate the semiconductor substrate 11. The structure of the present embodiment can be adopted, for example, in a case where the pixel separation groove 21 does not need to penetrate the semiconductor substrate 11 or in a case where it is desirable that the pixel separation groove 21 does not penetrate the semiconductor substrate 11. The solid-state imaging device of the present embodiment is manufactured, for example, by forming the pixel separation groove 21 that does not penetrate the semiconductor substrate 11 in the process illustrated in A of Fig. 7.

Note that the pixel separation groove 21 of the present embodiment may include both a portion penetrating the semiconductor substrate 11 and a portion not penetrating the semiconductor substrate 11.

### (Third Embodiment)

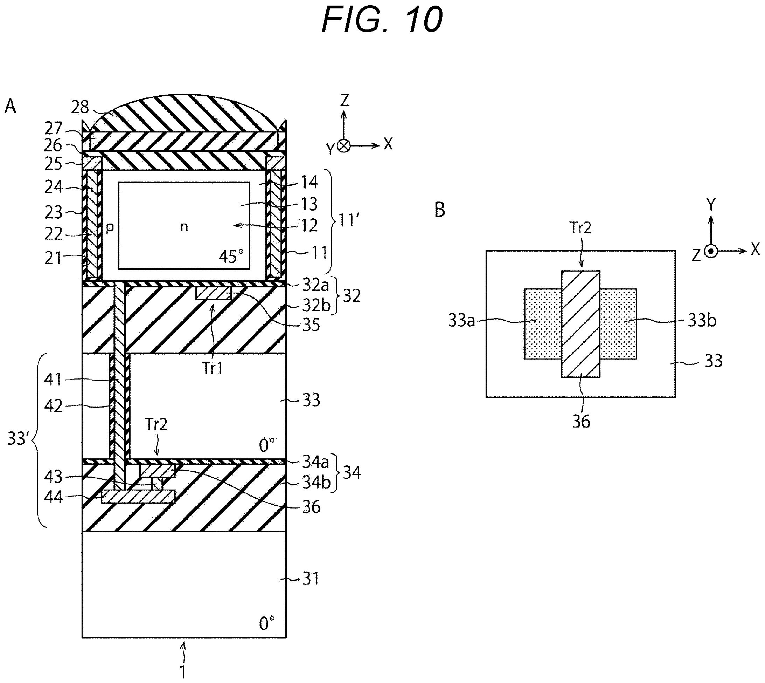

Fig. 10 is a cross-sectional view and a plan view illustrating a structure of a solid-state imaging device of a third embodiment.

A of Fig. 10 illustrates a longitudinal cross section of one pixel 1 in the pixel array region 2 of Fig. 1, similarly to A of Fig. 2. In addition to the components of the solid-state imaging device of the first embodiment, the solid-state imaging device of the present embodiment includes a semiconductor substrate 33, an insulating layer 34, a gate electrode 35 of a transistor Tr1, a gate electrode 36 of a transistor Tr2, a plug 41, an insulating film 42, a plug 43, and a wiring layer 44. Further, the insulating layer 32 includes an insulating film 32a functioning as a gate insulating film of the transistor Tr1 and an interlayer insulating film 32b, and the insulating layer 34 includes an insulating film 34a functioning as a gate insulating film of the transistor Tr2 and an interlayer insulating film 34b. The insulating layer 32 is an example of a first insulating layer of the present disclosure, and the semiconductor substrate 33 is an example of a second semiconductor substrate of the present disclosure. The solid-state imaging device of the present embodiment further includes a substrate 33' including a semiconductor substrate 33, an insulating layer 34, a gate electrode 36, a plug 41, an insulating film 42, a plug 43, and a wiring layer 44. The substrate 33' is an example of a second substrate of the present disclosure.

Hereinafter, the structure of the solid-state imaging device of the present embodiment will be described with reference to A of Fig. 10. In this description, B of Fig. 10 is also referred to as appropriate. B of Fig. 10 is a plan view illustrating a structure of the semiconductor substrate 33 and the gate electrode 36.

The insulating layer 32 includes an insulating film 32a and an interlayer insulating film 32b sequentially provided on the surface (lower surface) of the semiconductor substrate 11. The insulating film 32a is, for example, a silicon oxide film. The interlayer insulating film 32b is, for example, a laminated film including a silicon oxide film and another insulating film. The semiconductor substrate 33 is provided on the lower surface of the insulating layer 32. The semiconductor substrate 33 is, for example, a silicon substrate. The insulating layer 34 includes an insulating film 34a and an interlayer insulating film 34b sequentially provided on the surface (lower surface) of the semiconductor substrate 33. The insulating film 34a is, for example, a silicon oxide film. The interlayer insulating film 34b is, for example, a laminated film including a silicon oxide film and another insulating film. The substrate 31 is provided on the lower surface of the insulating layer 34.

As described above, the solid-state imaging device of the present embodiment includes the semiconductor substrate 33 in addition to the semiconductor substrate 11 and the substrate 31. Similarly to the semiconductor substrate 11 of the first embodiment, the semiconductor substrate 11 of the present embodiment has a front surface and a back surface which are {100} planes, and is a <100> notch substrate (45° notch substrate). On the other hand, the semiconductor substrate 33 of the present embodiment has a front surface and a back surface which are {100} planes, and is a <110> notch substrate (0° notch substrate). Therefore, in the semiconductor substrate 33 of the present embodiment, the +Y direction in the semiconductor substrate 33 is the <110> direction, similarly to the semiconductor substrate 11 of the comparative example described above illustrated in B of Fig. 3.

The gate electrode 35 of the transistor Tr1 is provided on the front surface (lower surface) of the semiconductor substrate 11 with the insulating film 32a interposed therebetween, and is covered with the interlayer insulating film 32b. The transistor Tr1 is, for example, a pixel transistor such as a transfer transistor. The gate electrode 35 is, for example, a semiconductor layer or a metal layer. The transistor Tr1 further includes a source diffusion layer and a drain diffusion layer (not illustrated) provided in the substrate 31.

The gate electrode 36 of the transistor Tr2 is provided on the front surface (lower surface) of the semiconductor substrate 33 with the insulating film 34a interposed therebetween, and is covered with the interlayer insulating film 34b. The transistor Tr2 is, for example, a pixel transistor such as an amplification transistor. The gate electrode 36 is, for example, a semiconductor layer or a metal layer. As illustrated in B of Fig. 10, the transistor Tr2 further includes a source diffusion layer 33a and a drain diffusion layer 33b provided in the semiconductor substrate 33.

The transistor Tr2 of the present embodiment is an n-type planar transistor, and includes the source diffusion layer 33a and the drain diffusion layer 33b arranged in the X direction, and the gate electrode 36 extending in the Y direction (B of Fig. 10). Therefore, the channel direction of the transistor Tr2 of the present embodiment is the +X direction and is parallel to the <110> direction.

The performance of the n-type planar transistor is improved by making the channel direction parallel to the <110> direction of the silicon substrate. On the other hand, the semiconductor substrate 33 of the present embodiment is a <110> notch substrate as described above. Therefore, according to the present embodiment, by forming the source diffusion layer 33a and the drain diffusion layer 33b arranged in the X direction in the semiconductor substrate 33, the channel direction can be made parallel to the <110> direction, and thereby the performance of the transistor Tr2 can be improved.

Subsequently, the structure of the solid-state imaging device of the present embodiment will be described with reference to A of Fig. 10.

The wiring layer 44 is provided below the gate electrode 36 in the interlayer insulating film 34b. The plug 43 is provided in the interlayer insulating film 34b, and electrically connects the wiring layer 44 and the gate electrode 36. The plug 41 is provided in the insulating layer 34, the semiconductor substrate 33, and the insulating layer 32, and electrically connects the wiring layer 44 and the semiconductor substrate 11. Thus, the transistor Tr2 is electrically connected to the semiconductor substrate 11. Note that the plug 41 is provided in the semiconductor substrate 33 with the insulating film 42 interposed therebetween.

As described above, the solid-state imaging device according to the present embodiment includes the semiconductor substrate 11 that is the <100> notch substrate, and the semiconductor substrate 33 that is the <110> notch substrate. Therefore, according to the present embodiment, it is possible to suitably form the n-type planar transistor (transistor Tr2) on the surface of the semiconductor substrate 33 while suitably forming the pixel separation section 32 in the semiconductor substrate 11.

### (Fourth Embodiment)

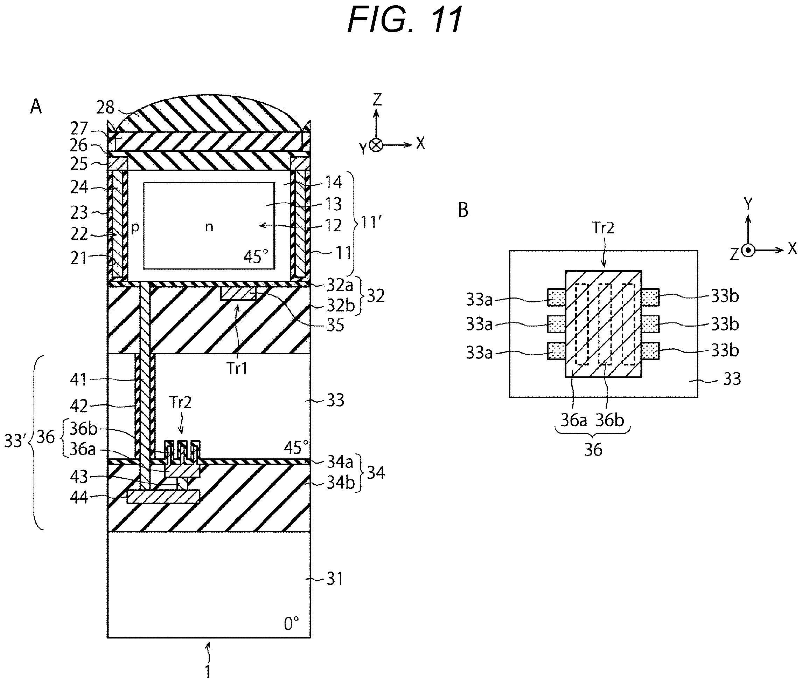

Fig. 11 is a cross-sectional view and a plan view illustrating a structure of a solid-state imaging device according to a fourth embodiment.

A of Fig. 11 illustrates a longitudinal cross section of one pixel 1 in the pixel array region 2 of Fig. 1, similarly to A of Fig. 10. B of Fig. 11 is a plan view illustrating a structure of the semiconductor substrate 33 and the gate electrode 36 similarly to B of Fig. 10.

As illustrated in A and B of Fig. 11, the solid-state imaging device of the present embodiment includes the same components as those of the solid-state imaging device of the third embodiment. However, the semiconductor substrate 33 of the present embodiment has a front surface and a back surface which are {100} planes, and is a <100> notch substrate (45° notch substrate). Therefore, in the semiconductor substrate 33 of the present embodiment, the +Y direction in the semiconductor substrate 33 is the <100> direction. In addition, the transistor Tr2 of the present embodiment is a fin-type transistor, and the gate electrode 36 of the transistor Tr2 includes a planar portion 36a provided outside the semiconductor substrate 33 and a plurality of fin portions 36b provided in the semiconductor substrate 33.

As illustrated in B of Fig. 11, the transistor Tr2 of the present embodiment includes a plurality of source diffusion layers 33a and a plurality of drain diffusion layers 33b in the semiconductor substrate 33, and the source diffusion layer 33a and the drain diffusion layer 33b are arranged in the X direction. In addition, as illustrated in B of Fig. 11, the gate electrode 36 of the present embodiment includes a plurality of fin portions 36b in the semiconductor substrate 33, and these fin portions 36b extend in the Y direction. Therefore, the channel direction of the transistor Tr2 of the present embodiment is the +X direction and is parallel to the <100> direction, and the fin sidewall of the transistor Tr2 of the present embodiment is the side surface of the semiconductor substrate 33 extending in the Y direction and is the {100} plane.

The performance of the fin-type transistor is improved by making the fin sidewall the {100} plane of the silicon substrate. On the other hand, the semiconductor substrate 33 of the present embodiment is a <100> notch substrate as described above. Therefore, according to the present embodiment, by forming the fin portion 36b extending in the Y direction in the semiconductor substrate 33, it is possible to form the fin sidewall to a {100} plane, thereby improving the performance of the transistor Tr2.

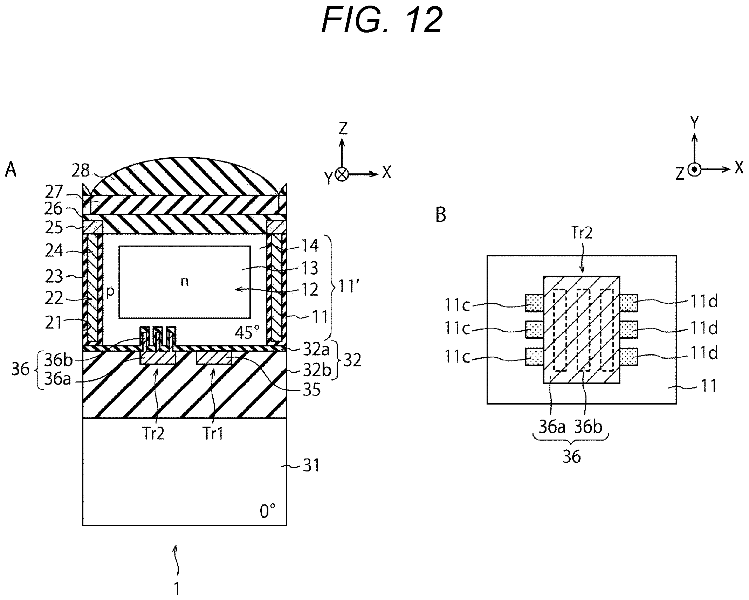

Fig. 12 is a cross-sectional view and a plan view illustrating a structure of a solid-state imaging device according to a modification of the fourth embodiment.

A and B in Fig. 12 correspond to A and B in Fig. 11, respectively. The solid-state imaging device of the present modification has a structure obtained by removing the semiconductor substrate 33 and the insulating layer 34 from the solid-state imaging device of the fourth embodiment, and the transistor Tr2 is formed not on the surface of the semiconductor substrate 33 but on the surface of the semiconductor substrate 11. Therefore, the gate insulating film of the transistor Tr2 is replaced from the insulating film 34a to the insulating film 32a, and the diffusion layer of the transistor Tr2 is replaced from the source diffusion layer 33a and the drain diffusion layer 33b in the semiconductor substrate 33 to the source diffusion layer 11c and the drain diffusion layer 11d in the semiconductor substrate 11. According to the present modification, the performance of the transistor Tr2 can be improved by using the semiconductor substrate 11 instead of the semiconductor substrate 33.

As described above, the solid-state imaging device according to the present embodiment includes the semiconductor substrate 11 that is the <100> notch substrate, and the semiconductor substrate 33 that is the <100> notch substrate. Therefore, according to the present embodiment, it is possible to suitably form the fin-type transistor (transistor Tr2) on the surface of the semiconductor substrate 33 while suitably forming the pixel separation section 32 in the semiconductor substrate 11. Note that the fin-type transistor may be formed on the surface of the semiconductor substrate 11 as in the modification described above.

### (Fifth Embodiment)

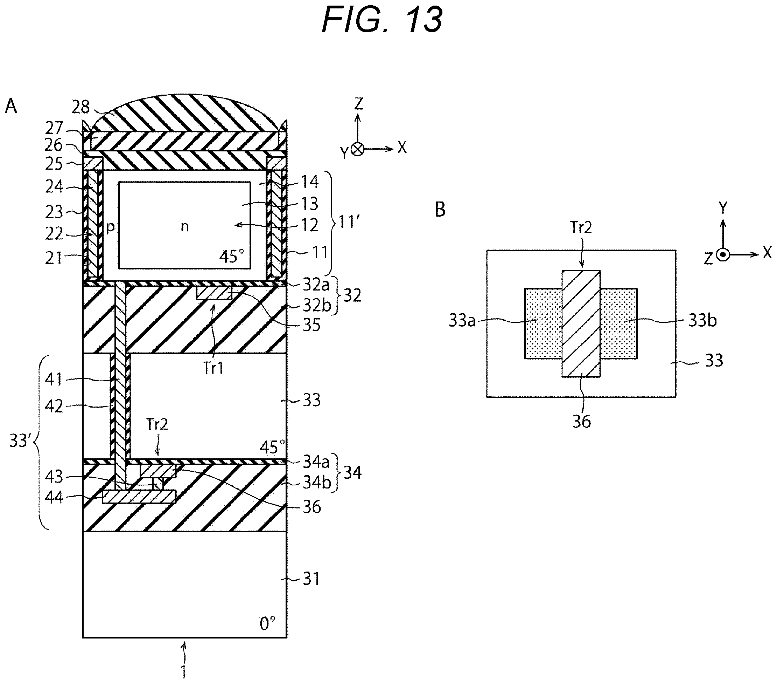

Fig. 13 is a cross-sectional view and a plan view illustrating a structure of a solid-state imaging device of a fifth embodiment.

A of Fig. 13 illustrates a longitudinal cross section of one pixel 1 in the pixel array region 2 of Fig. 1, similarly to A of Fig. 10. B of Fig. 13 is a plan view illustrating a structure of the semiconductor substrate 33 and the gate electrode 36 similarly to B of Fig. 10.

As illustrated in A and B of Fig. 13, the solid-state imaging device of the present embodiment includes the same components as those of the solid-state imaging device of the third embodiment. However, the semiconductor substrate 33 of the present embodiment has a front surface and a back surface which are {100} planes, and is a <100> notch substrate (45° notch substrate). Therefore, in the semiconductor substrate 33 of the present embodiment, the +Y direction in the semiconductor substrate 33 is the <100> direction.

The transistor Tr2 of the present embodiment is a p-type planar transistor, and includes the source diffusion layer 33a and thee drain diffusion layer 33b arranged in the X direction, and the gate electrode 36 extending in the Y direction (B of Fig. 13). Therefore, the channel direction of the transistor Tr2 of the present embodiment is the +X direction and is parallel to the <100> direction.

The performance of the p-type planar transistor is improved by making the channel direction parallel to the <100> direction of the silicon substrate. On the other hand, the semiconductor substrate 33 of the present embodiment is a <100> notch substrate as described above. Therefore, according to the present embodiment, by forming the source diffusion layer 33a and the drain diffusion layer 33b arranged in the X direction in the semiconductor substrate 33, the channel direction can be made parallel to the <100> direction, and thereby the performance of the transistor Tr2 can be improved.

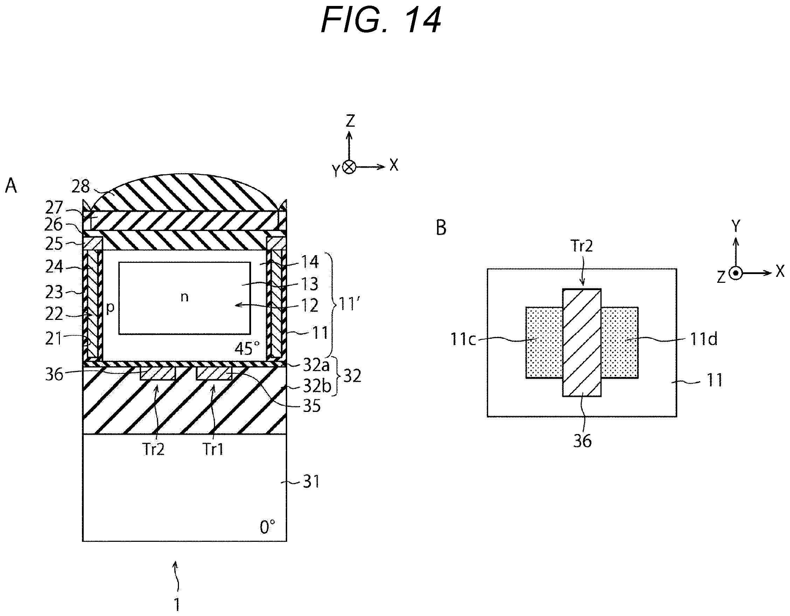

Fig. 14 is a cross-sectional view and a plan view illustrating a structure of a solid-state imaging device according to a modification of the fifth embodiment.

A and B in Fig. 14 correspond to A and B in Fig. 13, respectively. The solid-state imaging device of the present modification has a structure obtained by removing the semiconductor substrate 33 and the insulating layer 34 from the solid-state imaging device of the fifth embodiment, and the transistor Tr2 is formed not on the surface of the semiconductor substrate 33 but on the surface of the semiconductor substrate 11. Therefore, the gate insulating film of the transistor Tr2 is replaced from the insulating film 34a to the insulating film 32a, and the diffusion layer of the transistor Tr2 is replaced from the source diffusion layer 33a and the drain diffusion layer 33b in the semiconductor substrate 33 to the source diffusion layer 11c and the drain diffusion layer 11d in the semiconductor substrate 11. According to the present modification, the performance of the transistor Tr2 can be improved by using the semiconductor substrate 11 instead of the semiconductor substrate 33.

As described above, the solid-state imaging device according to the present embodiment includes the semiconductor substrate 11 that is the <100> notch substrate, and the semiconductor substrate 33 that is the <100> notch substrate. Therefore, according to the present embodiment, it is possible to suitably form the p-type planar transistor (transistor Tr2) on the surface of the semiconductor substrate 33 while suitably forming the pixel separation section 32 in the semiconductor substrate 11. Note that the p-type planar transistor may be formed on the surface of the semiconductor substrate 11 as in the modification described above.

### (Sixth Embodiment)

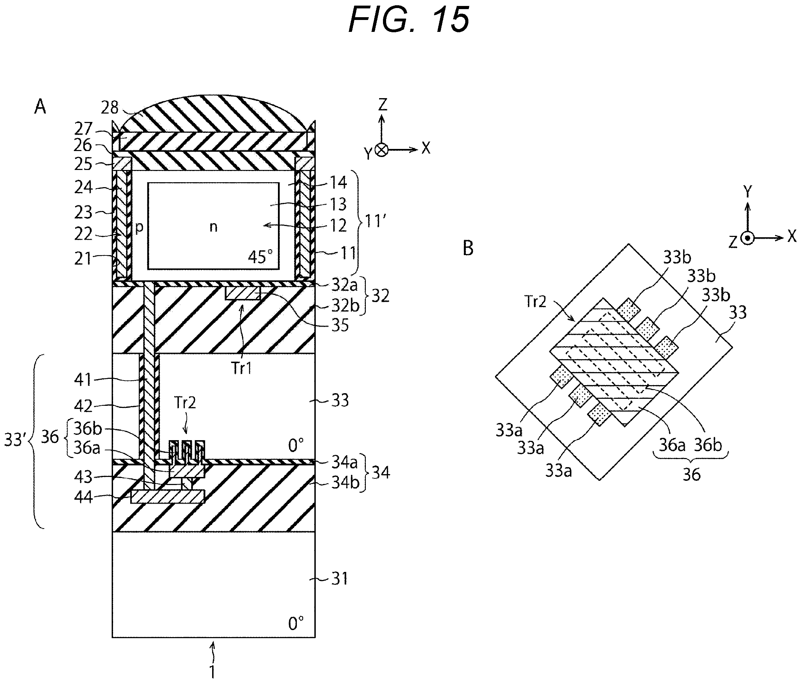

Fig. 15 is a cross-sectional view and a plan view illustrating a structure of a solid-state imaging device of a sixth embodiment.

A of Fig. 15 illustrates a longitudinal cross section of one pixel 1 in the pixel array region 2 of Fig. 1, similarly to A of Fig. 10. B of Fig. 15 is a plan view illustrating a structure of the semiconductor substrate 33 and the gate electrode 36 similarly to B of Fig. 10.

As illustrated in A and B of Fig. 15, the solid-state imaging device of the present embodiment includes the same components as those of the solid-state imaging device of the third embodiment. However, the semiconductor substrate 33 of the present embodiment has a front surface and a back surface which are {100} planes, and is a <110> notch substrate (0° notch substrate). Therefore, in the semiconductor substrate 33 of the present embodiment, the +Y direction in the semiconductor substrate 33 is the <110> direction. In addition, the transistor Tr2 of the present embodiment is a fin-type transistor, and the gate electrode 36 of the transistor Tr2 includes a planar portion 36a provided outside the semiconductor substrate 33 and a plurality of fin portions 36b provided in the semiconductor substrate 33.

As illustrated in B of Fig. 15, the transistor Tr2 of the present embodiment includes a plurality of source diffusion layers 33a and a plurality of drain diffusion layers 33b in the semiconductor substrate 33, and the source diffusion layer 33a and the drain diffusion layer 33b are arranged in a direction inclined by +45° with respect to the +X direction. In addition, as illustrated in B of Fig. 15, the gate electrode 36 of the present embodiment includes a plurality of fin portions 36b in the semiconductor substrate 33, and these fin portions 36b extend in a direction inclined at +45° with respect to the +Y direction. Therefore, the channel direction of the transistor Tr2 of the present embodiment is a direction inclined by +45° with respect to the +X direction and is parallel to the <100> direction, and the fin sidewall of the transistor Tr2 of the present embodiment is a side surface of the semiconductor substrate 33 extending in a direction inclined by +45° with respect to the +Y direction and is the {100} plane.

The performance of the fin-type transistor is improved by making the fin sidewall the {100} plane of the silicon substrate. On the other hand, the semiconductor substrate 33 of the present embodiment is a <110> notch substrate as described above. Therefore, according to the present embodiment, by forming the fin portion 36b extending in the direction described above in the semiconductor substrate 33, it is possible to form the fin sidewall to a {100} plane, thereby improving the performance of the transistor Tr2.

The planar shape of each pixel 1 of the present embodiment is a square (or rectangle) having two sides extending in the X direction and two sides extending in the Y direction. In a case where the fin portion 36b extends in the Y direction as in the transistor Tr2 of the fourth embodiment, the length of the fin portion 36b is about the length of one side of the planar shape of each pixel 1 at the maximum. On the other hand, in a case where the fin portion 36b extends in the oblique direction as in the transistor Tr2 of the present embodiment, the length of the fin portion 36b is about √2 times the length of one side of the planar shape of each pixel 1 at the maximum. As described above, according to the present embodiment, the length of the fin portion 36b can be increased, whereby the performance of the transistor Tr2 can be further improved.

As described above, the solid-state imaging device according to the present embodiment includes the semiconductor substrate 11 that is the <100> notch substrate, and the semiconductor substrate 33 that is the <110> notch substrate. Therefore, according to the present embodiment, it is possible to suitably form the fin-type transistor (transistor Tr2) on the surface of the semiconductor substrate 33 while suitably forming the pixel separation section 32 in the semiconductor substrate 11.

Note that the channel direction of the transistor Tr2 of the present embodiment may be a direction inclined by +θ with respect to the +X direction (0° < θ < 90°). In addition, the fin portion 36b of the present embodiment may extend in a direction inclined by +θ with respect to the +Y direction. The value of θ may be an angle other than 45°.

### (Application Example)

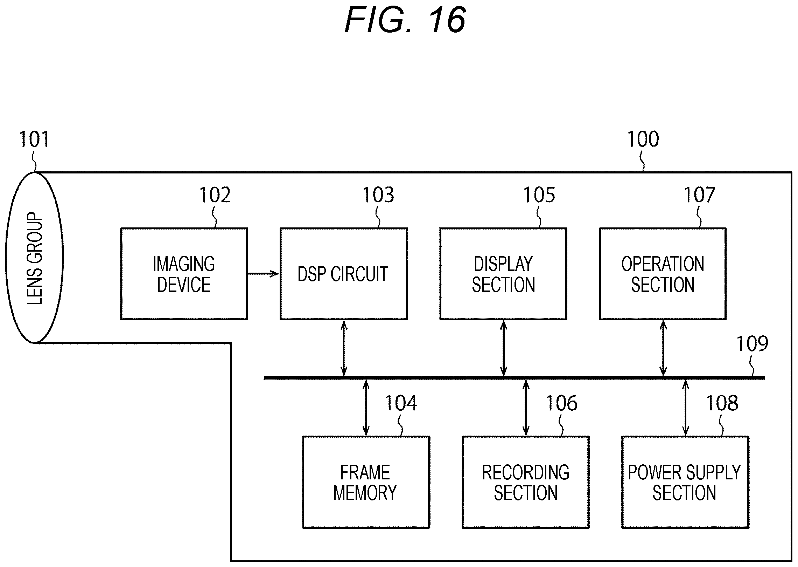

Fig. 16 is a block diagram illustrating a configuration example of an electronic device. An electrical device illustrated in Fig. 16 is a camera 100.

The camera 100 includes an optical section 101 including a lens group and the like, an imaging device 102 which is the solid-state imaging device according to any one of the first to sixth embodiments, a digital signal processor (DSP) circuit 103 which is a camera signal processing circuit, a frame memory 104, a display section 105, a recording section 106, an operation section 107, and a power supply section 108. In addition, the DSP circuit 103, the frame memory 104, the display section 105, the recording section 106, the operation section 107, and the power supply section 108 are connected to one another via a bus line 109.

The optical section 101 captures incident light (image light) from a subject and forms an image on an imaging surface of the imaging device 102. The imaging device 102 converts the light amount of the incident light imaged on the imaging surface by the optical section 101 into an electrical signal in units of pixels, and outputs the electrical signal as a pixel signal.

The DSP circuit 103 performs signal processing on the pixel signal output from the imaging device 102. The frame memory 104 is a memory for storing one screen of a moving image or a still image captured by the imaging device 102.

The display section 105 includes, for example, a panel type display apparatus such as a liquid crystal panel or an organic EL panel, and displays a moving image or a still image captured by the imaging device 102. The recording section 106 records the moving image or the still image captured by the imaging device 102 on a recording medium such as a hard disk or a semiconductor memory.

The operation section 107 issues operation commands for various functions of the camera 100 under operation by the user. The power supply section 108 appropriately supplies various power sources serving as operation power sources of the DSP circuit 103, the frame memory 104, the display section 105, the recording section 106, and the operation section 107 to these supply targets.

By using the solid-state imaging device according to any one of the first to sixth embodiments as the imaging device 102, acquisition of a good image can be expected.

The solid-state imaging device can be applied to various other products. For example, the solid-state imaging device may be mounted on various moving bodies such as an automobile, an electric vehicle, a hybrid electric vehicle, a motorcycle, a bicycle, a personal mobility, an airplane, a drone, a ship, and a robot.

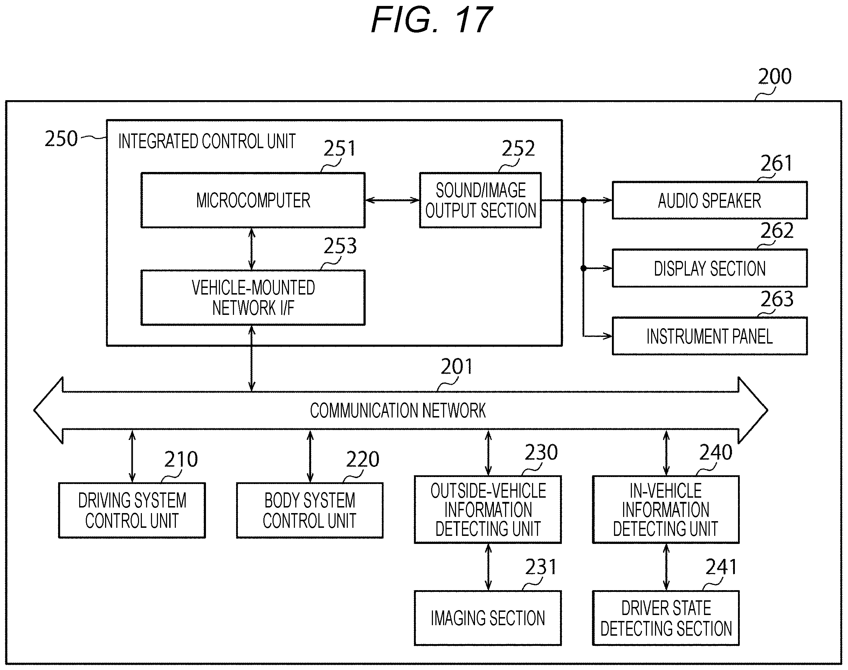

Fig. 17 is a block diagram illustrating a configuration example of a moving body control system. The moving body control system illustrated in Fig. 17 is a vehicle control system 200.

The vehicle control system 200 includes a plurality of electronic control units connected via a communication network 201. In the example depicted in Fig. 17, the vehicle control system 200 includes a driving system control unit 210, a body system control unit 220, an outside-vehicle information detecting unit 230, an in-vehicle information detecting unit 240, and an integrated control unit 250. Fig. 17 further illustrates a microcomputer 251, a sound/image output section 252, and a vehicle-mounted network interface (I/F) 253 as components of the integrated control unit 250.

The driving system control unit 210 controls the operation of devices related to the driving system of the vehicle according to various programs. For example, the driving system control unit 210 functions as a control device of a driving force generating device for generating a driving force of the vehicle such as an internal combustion engine and a driving motor, a driving force transmitting mechanism for transmitting the driving force to wheels, a steering mechanism for adjusting a steering angle of the vehicle, a braking device for generating a braking force of the vehicle, and the like.

The body system control unit 220 controls operations of various devices mounted on the vehicle body according to various programs. For example, the body system control unit 220 functions as a control device for a smart key system, a keyless entry system, a power window device, various lamps (for example, a headlamp, a back lamp, a brake lamp, a blinker, and a fog lamp), or the like. In this case, radio waves transmitted from a portable device that substitutes for a key or signals of various switches can be input to the body system control unit 220. The body system control unit 220 receives such input of radio waves or signals, and controls a door lock device, a power window device, a lamp, and the like of the vehicle.

The outside-vehicle information detecting unit 230 detects information about the outside of the vehicle including the vehicle control system 200. For example, an imaging section 231 is connected to the outside-vehicle information detecting unit 230. The outside-vehicle information detecting unit 230 causes the imaging section 231 to capture an image outside the vehicle, and receives the captured image from the imaging section 231. The outside-vehicle information detecting unit 230 may perform object detection processing or distance detection processing of a person, a vehicle, an obstacle, a sign, a character on a road surface, or the like on the basis of the received image.

The imaging section 231 is an optical sensor that receives light and outputs an electric signal corresponding to the amount of received light. The imaging section 231 can output the electric signal as an image or can output the electric signal as distance measurement information. The light received by the imaging section 231 may be visible light or invisible light such as infrared rays. The imaging section 231 includes the solid-state imaging device according to any one of the first to sixth embodiments.

The in-vehicle information detecting unit 240 detects information inside the vehicle on which the vehicle control system 200 is mounted. For example, a driver state detecting section 241 that detects a state of a driver is connected to the in-vehicle information detecting unit 240. For example, the driver state detecting section 241 may include a camera that images the driver, and the in-vehicle information detecting unit 240 may calculate the degree of fatigue or the degree of concentration of the driver on the basis of the detection information input from the driver state detecting section 241, or may determine whether or not the driver is dozing off. The camera may include the solid-state imaging device according to any one of the first to sixth embodiments, and may be, for example, the camera 100 illustrated in Fig. 16.

The microcomputer 251 can calculate a control target value of the driving force generating device, the steering mechanism, or the braking device on the basis of the information inside and outside the vehicle acquired by the outside-vehicle information detecting unit 230 or the in-vehicle information detecting unit 240, and output a control command to the driving system control unit 210. For example, the microcomputer 251 can perform cooperative control for the purpose of implementing functions of an advanced driver assistance system (ADAS) such as vehicle collision avoidance, impact mitigation, follow-up traveling based on an inter-vehicle distance, vehicle speed maintaining traveling, collision warning, and lane departure warning.

Furthermore, the microcomputer 251 controls the driving force generating device, the steering mechanism, or the braking device on the basis of the information around the vehicle acquired by the outside-vehicle information detecting unit 230 or the in-vehicle information detecting unit 240, thereby performing cooperative control for the purpose of automated driving or the like in which the vehicle automatedly travels without depending on the operation of the driver.

Furthermore, the microcomputer 251 can output a control command to the body system control unit 220 on the basis of the outside-vehicle information acquired by the outside-vehicle information detecting unit 230. For example, the microcomputer 251 can perform cooperative control for the purpose of preventing glare, such as switching from a high beam to a low beam, by controlling the headlamp according to the position of a preceding vehicle or an oncoming vehicle detected by the outside-vehicle information detecting unit 230.

The sound/image output section 252 transmits an output signal of at least one of a sound or an image to an output device capable of visually or audibly notifying an occupant of the vehicle or the outside of the vehicle of information. In the example of Fig. 17, an audio speaker 261, a display section 262, and an instrument panel 263 are illustrated as such output devices. The display section 262 may include, for example, an on-board display or a head-up display.

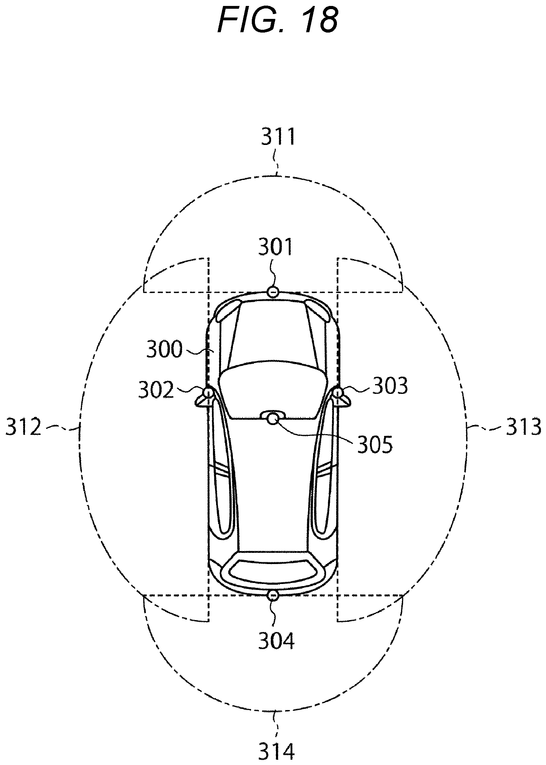

Fig. 18 is a plan view illustrating a specific example of a setting position of the imaging section 231 in Fig. 17.

A vehicle 300 illustrated in Fig. 18 includes imaging sections 301, 302, 303, 304, and 305 as the imaging section 231. The imaging sections 301, 302, 303, 304, and 305 are provided, for example, at positions such as a front nose, a sideview mirror, a rear bumper, a back door, and an upper portion of a windshield in a vehicle interior of the vehicle 300.

The imaging section 301 provided at the front nose mainly acquires an image in front of the vehicle 300. The imaging section 302 provided on the left sideview mirror and the imaging section 303 provided on the right sideview mirror mainly acquire images of the sides of the vehicle 300. The imaging section 304 provided on the rear bumper or the back door mainly acquires an image behind the vehicle 300. The imaging section 305 provided at the upper portion of the windshield in the vehicle interior mainly acquires an image ahead of the vehicle 300. The imaging section 305 is used to detect, for example, a preceding vehicle, a pedestrian, an obstacle, a traffic light, a traffic sign, a lane, and the like.

Fig. 18 illustrates an example of imaging ranges of the imaging sections 301, 302, 303, and 304 (hereinafter referred to as "imaging sections 301 to 304 "). An imaging range 311 indicates an imaging range of the imaging section 301 provided at the front nose. Imaging range 312 indicates an imaging range of imaging section 302 provided on the left sideview mirror. An imaging range 313 indicates an imaging range of the imaging section 303 provided on the right sideview mirror. An imaging range 314 indicates an imaging range of the imaging section 304 provided on the rear bumper or the back door. For example, a bird's-eye image of the vehicle 300 viewed from above can be obtained by superimposing image data captured by the imaging sections 301 to 304. Hereinafter, the imaging ranges 311, 312, 313, and 314 are referred to as an "imaging ranges 311 to 314".

At least one of the imaging sections 301 to 304 may have a function of acquiring distance information. For example, at least one of the imaging sections 301 to 304 may be a stereo camera including a plurality of imaging devices, or may be an imaging device having pixels for phase difference detection.

For example, the microcomputer 251 (Fig. 17) calculates the distance to each three-dimensional object in the imaging ranges 311 to 314 and the temporal change of the distance (relative speed with respect to the vehicle 300) on the basis of the distance information obtained from the imaging sections 301 to 304. On the basis of these calculation results, the microcomputer 251 can extract, as a preceding vehicle, a closest three-dimensional object on a traveling path of the vehicle 300, the three-dimensional object traveling at a predetermined speed (for example, 0 km/h or more) in substantially the same direction as the vehicle 300. Furthermore, the microcomputer 251 can set an inter-vehicle distance to be secured in advance in front of the preceding vehicle, and can perform automatic brake control (including follow-up stop control), automatic acceleration control (including follow-up start control), and the like. As described above, according to this example, it is possible to perform cooperative control for the purpose of automated driving or the like that automatedly travels without depending on the operation of the driver.

For example, on the basis of the distance information obtained from the imaging sections 301 to 304, the microcomputer 251 can classify and extract three-dimensional object data regarding three-dimensional objects into two-wheeled vehicles, standard-sized vehicles, large-sized vehicles, pedestrians, utility poles, and other three-dimensional objects, and use the three-dimensional object data for automatic avoidance of obstacles. For example, the microcomputer 251 identifies obstacles around the vehicle 300 as an obstacle that can be visually recognized by the driver of the vehicle 300 and an obstacle that is difficult to visually recognize. Then, the microcomputer 251 determines a collision risk indicating a risk of collision with each obstacle, and when the collision risk is a set value or more and there is a possibility of collision, the microcomputer can perform driving assistance for collision avoidance by outputting an alarm to the driver via the audio speaker 261 or the display section 262 or performing forced deceleration or avoidance steering via the driving system control unit 210.

At least one of the imaging sections 301 to 304 may be an infrared camera that detects infrared rays. For example, the microcomputer 251 can recognize a pedestrian by determining whether or not a pedestrian is present in the captured image of the imaging sections 301 to 304. Such pedestrian recognition is performed, for example, by a procedure of extracting feature points in an image captured by the imaging sections 301 to 304 as an infrared camera and a procedure of performing pattern matching processing on a series of feature points indicating a contour of an object to determine whether or not the object is a pedestrian. When the microcomputer 251 determines that a pedestrian is present in the captured image of the imaging sections 301 to 304 and recognizes the pedestrian, the sound/image output section 252 controls the display section 262 to superimpose and display a square contour line for emphasis on the recognized pedestrian. Furthermore, the sound/image output section 252 may control the display section 262 to display an icon or the like indicating a pedestrian at a desired position.

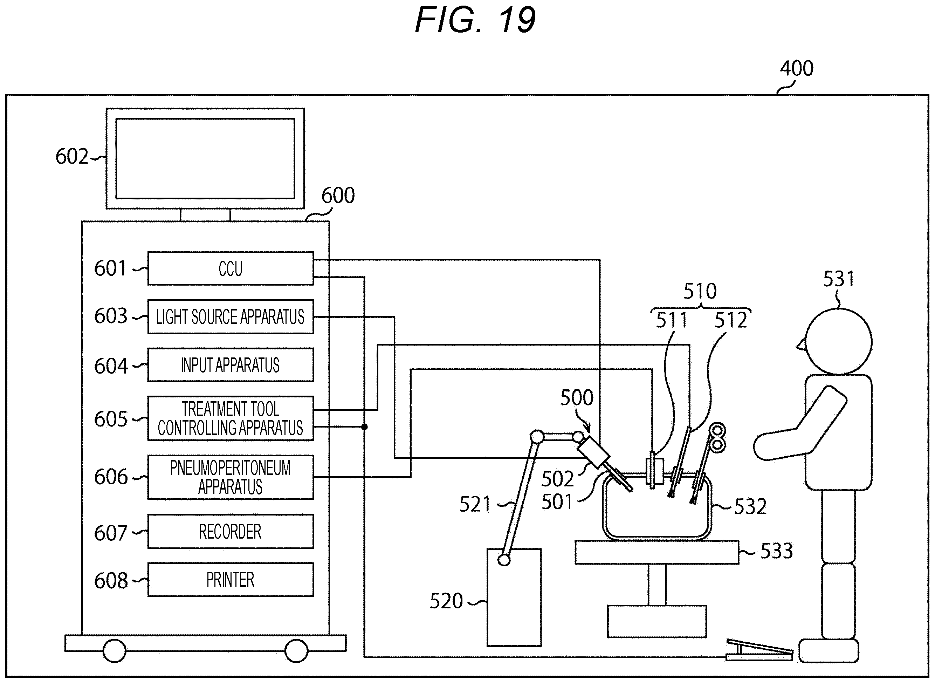

Fig. 19 is a diagram illustrating an example of a schematic configuration of an endoscopic surgery system to which the technology according to the present disclosure (the present technology) can be applied.

Fig. 19 illustrates a state in which a surgeon (medical doctor) 531 is performing surgery on a patient 532 on a patient bed 533 using an endoscopic surgery system 400. As illustrated, the endoscopic surgery system 400 includes an endoscope 500, other surgical tools 510 such as a pneumoperitoneum tube 511 and an energy device 512, a supporting arm apparatus 520 that supports the endoscope 500, and a cart 600 on which various apparatuses for endoscopic surgery are mounted.

The endoscope 500 includes a lens barrel 501 whose region of a predetermined length from the distal end is inserted into the body cavity of the patient 532, and a camera head 502 connected to the proximal end of the lens barrel 501. In the illustrated example, the endoscope 500 configured as a so-called rigid endoscope having the rigid lens barrel 501 is illustrated, but the endoscope 500 may be configured as a so-called flexible endoscope having a flexible lens barrel.

An opening into which an objective lens is fitted is provided at the distal end of the lens barrel 501. A light source apparatus 603 is connected to the endoscope 500, and light generated by the light source apparatus 603 is guided to the distal end of the lens barrel by a light guide extending inside the lens barrel 501, and is emitted toward an observation target in the body cavity of the patient 532 via the objective lens. Note that the endoscope 500 may be a forward-viewing endoscope, an oblique-viewing endoscope, or a side-viewing endoscope.

An optical system and an imaging element are provided inside the camera head 502, and reflected light (observation light) from the observation target is condensed on the imaging element by the optical system. The observation light is photoelectrically converted by the imaging element, and an electric signal corresponding to the observation light, that is, an image signal corresponding to the observation image is generated. The image signal is transmitted to a camera control unit (CCU) 601 as RAW data.

The CCU 601 includes a central processing unit (CPU), a graphics processing unit (GPU), and the like, and integrally controls operation of the endoscope 500 and a display apparatus 602. Furthermore, the CCU 601 receives an image signal from the camera head 502, and performs various types of image processing for displaying an image based on the image signal, such as development processing (demosaic processing), on the image signal.

The display apparatus 602 displays an image based on the image signal subjected to the image processing by the CCU 601 under the control of the CCU 601.

The light source apparatus 603 includes a light source such as a light emitting diode (LED), for example, and supplies irradiation light for imaging a surgical site or the like to the endoscope 500.

An input apparatus 604 is an input interface for the endoscopic surgery system 11000. The user can input various types of information and instructions to the endoscopic surgery system 400 via the input apparatus 604. For example, the user inputs an instruction or the like to change imaging conditions (type of irradiation light, magnification, focal length, and the like) by the endoscope 500.

A treatment tool controlling apparatus 605 controls driving of the energy device 512 for cauterization and incision of tissue, sealing of a blood vessel, or the like. A pneumoperitoneum apparatus 606 feeds gas into the body cavity of the patient 532 via the pneumoperitoneum tube 511 in order to inflate the body cavity for the purpose of securing a visual field by the endoscope 500 and securing a working space of the surgeon. A recorder 607 is an apparatus capable of recording various types of information regarding surgery. A printer 608 is an apparatus capable of printing various types of information regarding surgery in various formats such as text, image, or graph.

Note that the light source apparatus 603 that supplies the endoscope 500 with the irradiation light at the time of imaging the surgical site can include, for example, an LED, a laser light source, or a white light source including a combination thereof. In a case where the white light source includes a combination of RGB laser light sources, since the output intensity and the output timing of each color (each wavelength) can be controlled with high accuracy, adjustment of the white balance of the captured image can be performed in the light source apparatus 603. Furthermore, in this case, by irradiating the observation target with the laser light from each of the RGB laser light sources in a time division manner and controlling the driving of the imaging element of the camera head 502 in synchronization with the irradiation timing, it is also possible to capture an image corresponding to each of RGB in a time division manner. According to this method, a color image can be obtained without providing a color filter in the imaging element.

Furthermore, the driving of the light source apparatus 603 may be controlled so as to change the intensity of light to be output every predetermined time. By controlling the driving of the imaging element of the camera head 502 in synchronization with the timing of the change of the light intensity to acquire images in a time division manner and synthesizing the images, it is possible to generate an image of a high dynamic range without so-called blocked up shadows and overexposed highlights.

Furthermore, the light source apparatus 603 may be configured to be able to supply light in a predetermined wavelength band corresponding to special light observation. In the special light observation, for example, so-called narrow band imaging is performed in which a predetermined tissue such as a blood vessel in a superficial portion of the mucous membrane is imaged with high contrast by irradiating light in a narrower band than irradiation light (that is, white light) at the time of normal observation using wavelength dependency of light absorption in a body tissue. Alternatively, in the special light observation, fluorescent observation for obtaining an image by fluorescence generated by irradiation with excitation light may be performed. In the fluorescent observation, it is possible to irradiate a body tissue with excitation light to observe fluorescence from the body tissue (autofluorescence observation), or to locally inject a reagent such as indocyanine green (ICG) into a body tissue and irradiate the body tissue with excitation light corresponding to a fluorescent light wavelength of the reagent to obtain a fluorescent light image, for example. The light source apparatus 603 can be configured to be able to supply narrow band light and/or excitation light corresponding to such special light observation.

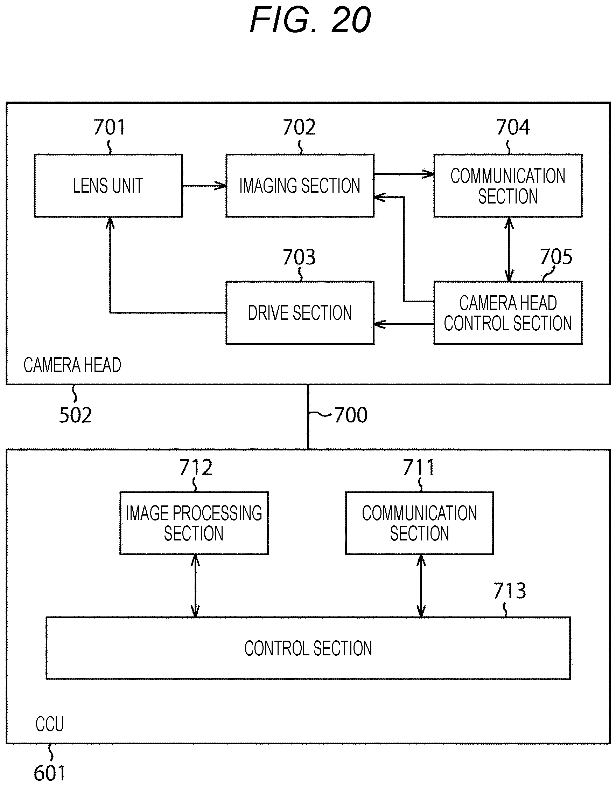

Fig. 20 is a block diagram illustrating an example of functional configurations of the camera head 502 and the CCU 601 illustrated in Fig. 19.

The camera head 502 includes a lens unit 701, an imaging section 702, a drive section 703, a communication section 704, and a camera head control section 705. The CCU 601 includes a communication section 711, an image processing section 712, and a control section 713. The camera head 502 and the CCU 601 are communicably connected to each other by a transmission cable 700.

The lens unit 701 is an optical system provided at a connection portion with the lens barrel 501. Observation light taken in from the distal end of the lens barrel 501 is guided to the camera head 502 and enters the lens unit 701. The lens unit 701 is configured by combining a plurality of lenses including a zoom lens and a focus lens.

The imaging section 702 includes an imaging element. The number of imaging elements constituting the imaging section 702 may be one (so-called single-plate type) or a plurality of (so-called multi-plate type). In a case where the imaging section 702 is configured as a multi-plate type, for example, image signals corresponding to RGB may be generated by the respective imaging elements, and a color image may be obtained by combining the image signals. Alternatively, the imaging section 702 may include a pair of imaging elements for acquiring right-eye and left-eye image signals corresponding to three-dimensional (3D) display. By performing the 3D display, the surgeon 531 can more accurately grasp the depth of the living tissue in the surgical site. Note that, in a case where the imaging section 702 is configured as a multi-plate type, a plurality of lens units 701 can be provided corresponding to the respective imaging elements. The imaging section 702 is, for example, the solid-state imaging device according to any one of the first to sixth embodiments.

Furthermore, the imaging section 702 is not necessarily provided in the camera head 502. For example, the imaging section 702 may be provided immediately after the objective lens inside the lens barrel 501.

The drive section 703 includes an actuator, and moves the zoom lens and the focus lens of the lens unit 701 by a predetermined distance along the optical axis under the control of the camera head control section 705. As a result, the magnification and focus of the image captured by the imaging section 702 can be appropriately adjusted.

The communication section 704 includes a communication apparatus for transmitting and receiving various types of information to and from the CCU 601. The communication section 704 transmits the image signal obtained from the imaging section 702 as RAW data to the CCU 601 via the transmission cable 700.

Furthermore, the communication section 704 receives a control signal for controlling driving of the camera head 502 from the CCU 601, and supplies the control signal to the camera head control section 705. The control signal includes, for example, information regarding imaging conditions such as information for specifying a frame rate of a captured image, information for specifying an exposure value at the time of imaging, and/or information for specifying a magnification and a focus of a captured image.

Note that the imaging conditions such as the frame rate, the exposure value, the magnification, and the focus described above may be appropriately specified by the user, or may be automatically set by the control section 713 of the CCU 601 on the basis of the acquired image signal. In the latter case, a so-called auto exposure (AE) function, an auto focus (AF) function, and an auto white balance (AWB) function are installed in the endoscope 500.

The camera head control section 705 controls driving of the camera head 502 on the basis of the control signal from the CCU 601 received via the communication section 704.

The communication section 711 includes a communication apparatus for transmitting and receiving various types of information to and from the camera head 502. The communication section 711 receives an image signal transmitted from the camera head 502 via the transmission cable 700.

Furthermore, the communication section 711 transmits a control signal for controlling driving of the camera head 502 to the camera head 502. The image signal and the control signal can be transmitted by electric communication, optical communication, or the like.

The image processing section 712 performs various types of image processing on the image signal that is RAW data transmitted from the camera head 502.

The control section 713 performs various types of control related to imaging of a surgical site or the like by the endoscope 500 and display of a captured image obtained by imaging of the surgical site or the like. For example, the control section 713 generates a control signal for controlling driving of the camera head 502.

Furthermore, the control section 713 causes the display apparatus 602 to display a captured image of a surgical site or the like on the basis of the image signal subjected to the image processing by the image processing section 712. At this time, the control section 713 may recognize various objects in the captured image using various image recognition technologies. For example, the control section 713 can recognize a surgical tool such as forceps, a specific body part, bleeding, mist at the time of using the energy device 512, and the like by detecting the shape, color, and the like of the edge of the object included in the captured image. When displaying the captured image on the display apparatus 602, the control section 713 may superimpose and display various types of surgery support information on the image of the surgical site by using the recognition result. Since the surgery support information is superimposed and displayed and presented to the surgeon 531, the burden on the surgeon 531 can be reduced and the surgeon 531 can reliably proceed with the surgery.

The transmission cable 700 connecting the camera head 502 and the CCU 601 is an electric signal cable compatible with electric signal communication, an optical fiber compatible with optical communication, or a composite cable thereof.

Here, in the illustrated example, communication is performed by wire using the transmission cable 700, but communication between the camera head 502 and the CCU 601 may be performed wirelessly.

Although the embodiments of the present disclosure have been described above, these embodiments may be implemented with various modifications without departing from the gist of the present disclosure. For example, two or more embodiments may be implemented in combination.

Note that the present disclosure can also have the following configurations.

(1) A solid-state imaging device including:
   a first substrate including a first semiconductor substrate;
   a plurality of photoelectric conversion sections provided in the first semiconductor substrate; and
   a pixel separation section provided between the plurality of photoelectric conversion sections in the first semiconductor substrate,
   in which an interface between a side surface of the pixel separation section and the first semiconductor substrate has a {100} plane.
(2) The solid-state imaging device according to (1), in which the pixel separation section includes an insulating film.
(3) The solid-state imaging device according to (2), in which the pixel separation section further includes a light shielding film.
(4) The solid-state imaging device according to (2), in which the insulating film contains an element contained in the first semiconductor substrate and oxygen.
(5) The solid-state imaging device according to (2), in which the insulating film includes a first portion having a first film thickness in plan view, and a second portion provided at a corner portion of the pixel separation section and having a second film thickness thicker than the first film thickness.
(6) The solid-state imaging device according to (1), in which the pixel separation section includes a plurality of first portions extending in a first direction parallel to a surface of the first semiconductor substrate in plan view, and a plurality of second portions extending in a second direction parallel to the surface of the first semiconductor substrate.
(7) The solid-state imaging device according to (5), in which the plan view corresponds to a state in which a light incident surface of the first semiconductor substrate is viewed.
(8) The solid-state imaging device according to (6), in which the first or second direction is parallel to a <100> direction of the first semiconductor substrate.
(9) The solid-state imaging device according to (1), in which the pixel separation section is provided in a pixel separation groove penetrating the first semiconductor substrate.
(10) The solid-state imaging device according to (1), in which the pixel separation section is provided in a pixel separation groove that does not penetrate the first semiconductor substrate.
(11) The solid-state imaging device according to (1), further including:
   a first insulating layer provided on a side opposite to a light incident surface of the first substrate; and
   a second substrate including a second semiconductor substrate provided so as to face the first insulating layer,
   in which the second substrate includes a transistor.
(12) The solid-state imaging device according to (11), in which the pixel separation section includes a plurality of first portions extending in a first direction parallel to a surface of the first semiconductor substrate in plan view, and a plurality of second portions extending in a second direction parallel to the surface of the first semiconductor substrate.
(13) The solid-state imaging device according to (12),
   in which the first or second direction is parallel to a <110> direction of the second semiconductor substrate, and
   the transistor is an n-type planar transistor having a channel direction parallel to a <110> direction.
(14) The solid-state imaging device according to (12),
   in which the first or second direction is parallel to a <100> direction of the second semiconductor substrate, and
   the transistor is a fin-type transistor having a fin sidewall that is a {100} plane of the second semiconductor substrate and having a channel direction parallel to the first or second direction.
(15) The solid-state imaging device according to (12),
   in which the first or second direction is parallel to a <100> direction of the second semiconductor substrate, and
   the transistor is a p-type planar transistor having a channel direction parallel to a <100> direction.
(16) The solid-state imaging device according to (12),
   in which the first or second direction is parallel to a <110> direction of the second semiconductor substrate, and
   the transistor is a fin-type transistor having a fin sidewall that is a {100} plane of the second semiconductor substrate and having a channel direction non-parallel to the first and second directions.
(17) A solid-state imaging device including:
   a first substrate including a first semiconductor substrate;
   a plurality of photoelectric conversion sections provided in the first semiconductor substrate; and
   a pixel separation section provided between the plurality of photoelectric conversion sections in the first semiconductor substrate,
   in which the pixel separation section includes an insulating film, and
   the insulating film includes a first portion having a first film thickness in plan view, and a second portion provided at a corner portion of the pixel separation section and having a second film thickness thicker than the first film thickness.
(18) A method for manufacturing a solid-state imaging device, the method including:
   forming a plurality of photoelectric conversion sections in a first semiconductor substrate of a first substrate; and
   forming a pixel separation section between the plurality of photoelectric conversion sections in the first semiconductor substrate,
   in which the pixel separation section is formed such that an interface between a side surface of the pixel separation section and the first semiconductor substrate has a {100} plane.
(19) The method for manufacturing the solid-state imaging device according to (18), in which the pixel separation section is formed to include an insulating film.
(20) The method for manufacturing the solid-state imaging device according to (19), in which the insulating film is formed to include a first portion having a first film thickness in plan view, and a second portion provided at a corner portion of the pixel separation section and having a second film thickness thicker than the first film thickness.

### REFERENCE SIGNS LIST

- 1: Pixel
- 2: Pixel array region
- 3: Control circuit
- 4: Vertical drive circuit
- 5: Column signal processing circuit
- 6: Horizontal drive circuit
- 7: Output circuit
- 8: Vertical signal line
- 9: Horizontal signal line
- 11: Semiconductor substrate
- 11': Substrate
- 11a: Chip region
- 11b: Dicing region
- 11c: Source diffusion layer
- 11d: Drain diffusion layer
- 12: Photoelectric conversion section
- 13: n-type semiconductor region
- 14: p-type semiconductor region
- 21: Pixel separation groove
- 21a: First linear portion
- 21b: Second linear portion
- 22: Pixel separation section
- 22a: First linear portion
- 22b: Second linear portion
- 23: Insulating film
- 23a: First portion
- 23b: Second portion
- 24: Light shielding film
- 25: Light shielding film
- 26: Flattening film
- 27: Color filter
- 28: On-chip lens
- 31: Substrate
- 32: Insulating layer
- 32a: Insulating film
- 32b: Interlayer insulating film
- 33: Semiconductor substrate
- 33': Substrate
- 33a: Source diffusion layer
- 33b: Drain diffusion layer
- 34: Insulating layer
- 34a: Insulating film
- 34b: Interlayer insulating film
- 35: Gate electrode
- 36: Gate electrode
- 36a: Planar portion
- 36b: Fin portion
- 41: Plug
- 42: Insulating film
- 43: Plug
- 44: Wiring layer

## Claims

1. A solid-state imaging device comprising:
a first substrate including a first semiconductor substrate;
a plurality of photoelectric conversion sections provided in the first semiconductor substrate; and
a pixel separation section provided between the plurality of photoelectric conversion sections in the first semiconductor substrate,
wherein an interface between a side surface of the pixel separation section and the first semiconductor substrate has a {100} plane.

2. The solid-state imaging device according to claim 1, wherein the pixel separation section includes an insulating film.

3. The solid-state imaging device according to claim 2, wherein the pixel separation section further includes a light shielding film.

4. The solid-state imaging device according to claim 2, wherein the insulating film contains an element contained in the first semiconductor substrate and oxygen.

5. The solid-state imaging device according to claim 2, wherein the insulating film includes a first portion having a first film thickness in plan view, and a second portion provided at a corner portion of the pixel separation section and having a second film thickness thicker than the first film thickness.

6. The solid-state imaging device according to claim 1, wherein the pixel separation section includes a plurality of first portions extending in a first direction parallel to a surface of the first semiconductor substrate in plan view, and a plurality of second portions extending in a second direction parallel to the surface of the first semiconductor substrate.

7. The solid-state imaging device according to claim 5, wherein the plan view corresponds to a state in which a light incident surface of the first semiconductor substrate is viewed.

8. The solid-state imaging device according to claim 6, wherein the first or second direction is parallel to a <100> direction of the first semiconductor substrate.

9. The solid-state imaging device according to claim 1, wherein the pixel separation section is provided in a pixel separation groove penetrating the first semiconductor substrate.

10. The solid-state imaging device according to claim 1, wherein the pixel separation section is provided in a pixel separation groove that does not penetrate the first semiconductor substrate.

11. The solid-state imaging device according to claim 1, further comprising:
a first insulating layer provided on a side opposite to a light incident surface of the first substrate; and
a second substrate including a second semiconductor substrate provided so as to face the first insulating layer,
wherein the second substrate includes a transistor.

12. The solid-state imaging device according to claim 11, wherein the pixel separation section includes a plurality of first portions extending in a first direction parallel to a surface of the first semiconductor substrate in plan view, and a plurality of second portions extending in a second direction parallel to the surface of the first semiconductor substrate.

13. The solid-state imaging device according to claim 12,
wherein the first or second direction is parallel to a <110> direction of the second semiconductor substrate, and
the transistor is an n-type planar transistor having a channel direction parallel to a <110> direction.

14. The solid-state imaging device according to claim 12,
wherein the first or second direction is parallel to a <100> direction of the second semiconductor substrate, and
the transistor is a fin-type transistor having a fin sidewall that is a {100} plane of the second semiconductor substrate and having a channel direction parallel to the first or second direction.

15. The solid-state imaging device according to claim 12,
wherein the first or second direction is parallel to a <100> direction of the second semiconductor substrate, and
the transistor is a p-type planar transistor having a channel direction parallel to a <100> direction.

16. The solid-state imaging device according to claim 12,
wherein the first or second direction is parallel to a <110> direction of the second semiconductor substrate, and
the transistor is a fin-type transistor having a fin sidewall that is a {100} plane of the second semiconductor substrate and having a channel direction non-parallel to the first and second directions.

17. A solid-state imaging device comprising:
a first substrate including a first semiconductor substrate;
a plurality of photoelectric conversion sections provided in the first semiconductor substrate; and
a pixel separation section provided between the plurality of photoelectric conversion sections in the first semiconductor substrate,
wherein the pixel separation section includes an insulating film, and
the insulating film includes a first portion having a first film thickness in plan view, and a second portion provided at a corner portion of the pixel separation section and having a second film thickness thicker than the first film thickness.

18. A method for manufacturing a solid-state imaging device, the method comprising:
forming a plurality of photoelectric conversion sections in a first semiconductor substrate of a first substrate; and
forming a pixel separation section between the plurality of photoelectric conversion sections in the first semiconductor substrate,
wherein the pixel separation section is formed such that an interface between a side surface of the pixel separation section and the first semiconductor substrate has a {100} plane.

19. The method for manufacturing the solid-state imaging device according to claim 18, wherein the pixel separation section is formed to include an insulating film.

20. The method for manufacturing the solid-state imaging device according to claim 19, wherein the insulating film is formed to include a first portion having a first film thickness in plan view, and a second portion provided at a corner portion of the pixel separation section and having a second film thickness thicker than the first film thickness.
